(19) Europäisches Patentamt

European Patent Office

Office européen des brevets

(11) **EP 1 586 911 B1**

(12) **FASCICULE DE BREVET EUROPEEN**

(45) Date de publication et mention
de la délivrance du brevet:
**13.11.2013 Bulletin 2013/46**

(21) Numéro de dépôt: **05102795.1**

(22) Date de dépôt: **08.04.2005**

(51) Int Cl.:
*G01R 31/12* *(2006.01)*

(54) **Procédé de détection et de localisation de source de décharge partielle dans un appareil électrique**

Verfahren zur Detektion und Ortung einer Teilentladungsquelle in einem elektrischen Gerät

Process for detecting and locating a partial discharge source in an electrical apparatus

(84) Etats contractants désignés:
**AT BE BG CH CY CZ DE DK EE ES FI FR GB GR HU IE IS IT LI LT LU MC NL PL PT RO SE SI SK TR**

(30) Priorité: **13.04.2004 FR 0450729**

(43) Date de publication de la demande:
**19.10.2005 Bulletin 2005/42**

(73) Titulaire: **ALSTOM Technology Ltd**
**5400 Baden (CH)**

(72) Inventeurs:
• **Kuppuswamy, Raja**
**75018 Paris (FR)**

• **Louise, Sébastien**
**94470 Boissy Saint Leger (FR)**
• **Nzihou, Niemet**
**69005 Lyon (FR)**

(74) Mandataire: **Ahner, Philippe et al**
**BREVALEX**
**95 rue d'Amsterdam**
**75378 Paris Cedex 8 (FR)**

(56) Documents cités:
**WO-A-96/18112**

**Description**

**DOMAINE TECHNIQUE**

La présente invention est relative à un procédé de détection et de localisation de source de décharge partielle dans un appareil électrique tel un transformateur. Ce procédé, utilisé par exemple lors de tests de maintenance, permet de détecter et localiser simplement, rapidement et avec précision toute source de décharge partielle dans l'appareil électrique. Les fabricants de tels appareils électriques et leurs utilisateurs surveillent régulièrement l'apparition de décharges partielles car elles sont la cause de disfonctionnements de l'appareil et peuvent conduire à sa destruction.

**ÉTAT DE LA TECHNIQUE ANTÉRIEURE**

Les décharges partielles sont relatives à des charges électriques qui sont émises à l'intérieur de l'appareil électrique et qui sont dues à un défaut de son isolation électrique. L'appareil électrique se trouve dans une enceinte contenant un fluide acoustiquement conducteur. Dans le cas d'un transformateur haute tension, ses enroulements sont généralement isolés avec du papier imprégné d'un fluide diélectrique tel de l'huile. D'autres transformateurs sont de type sec et entourés d'air ou d'un autre gaz diélectrique.

Le défaut peut être dû à un claquage au niveau de l'isolant du transformateur. Une autre cause peut être la présence de contaminant dans le liquide ou d'une bulle de gaz tel que de l'air, un chemin conducteur peut apparaître et une étincelle peut se déclencher mais sans établissement d'un arc électrique, c'est pourquoi le terme décharge partielle est employé.

Il est connu que les décharges partielles dans les appareils électriques haute tension, tels que les gros transformateurs de puissance, sont associées à l'émission d'ondes hautes fréquences ou ultra hautes fréquences et d'ondes acoustiques (généralement ultrasonores) qui se propagent dans le fluide acoustiquement conducteur. Il est ainsi connu de détecter et de chercher à localiser ces sources de décharges partielles à l'aide de détecteurs acoustiques associés éventuellement avec des moyens de détection électriques des ondes hautes fréquences ou ultra hautes fréquences.

Les fréquences les plus élevées peuvent atteindre approximativement 2 GHz si le fluide diélectrique est un gaz et approximativement 1,5 GHz si le fluide diélectrique est un liquide.

Deux procédés de détection et de localisation sont décrits par exemple dans l'article [1] dont les références sont précisées à la fin de la description.

Dans le premier procédé, un détecteur acoustique est placé successivement en plusieurs endroits sur la paroi externe de l'enceinte. Dans chacune des positions, on détermine électriquement l'instant d'émission d'une décharge partielle et on mesure le temps que met l'onde acoustique, émise par la décharge partielle, pour être détectée par le détecteur acoustique. On considère que la propagation de l'onde acoustique se fait linéairement dans le fluide diélectrique à une vitesse connue (par exemple environ 1400 m/s pour de l'huile à température ambiante). La distance entre la source de décharge partielle et le détecteur acoustique peut être calculée. Avec au moins trois positions pour le détecteur acoustique, par triangulation, on peut déterminer les coordonnées de la source de décharge partielle. Cette méthode est explicitée dans le document référencé [2].

Dans la seconde méthode, on utilise simultanément au moins une paire de détecteurs acoustiques et on mesure la différence de temps mise par une onde acoustique pour parcourir la distance entre la source de décharge partielle et chacun des détecteurs de la paire. En connaissant les positions des détecteurs acoustiques, on définit un premier hyperboloïde sur lequel se situe la source de décharges partielles. En utilisant une autre paire de détecteurs acoustiques ou en déplaçant la première paire de détecteurs, on définit de la même façon un second hyperboloïde, la source de décharge partielle se situant à l'intersection entre les deux hyperboloïdes.

Dans les brevets [3, 4] un détecteur acoustique coopère, sur un même dispositif, avec un détecteur d'un signal haute fréquence (ou ultra haute fréquence) émis par la source de décharge partielle. Ce détecteur de signal haute fréquence sert à déterminer l'instant d'émission de la décharge partielle. La vitesse de propagation du signal haute fréquence est proche de la vitesse de la lumière et elle est beaucoup plus grande que la vitesse de propagation de l'onde acoustique.

Dans le brevet [3] trois détecteurs acoustiques arrangés en un triangle équilatéral dont le côté est compris entre 15 et 20 centimètres sont montés sur un même support. Cet ensemble de trois détecteurs qui doit être plaqué sur la paroi extérieure de l'enceinte du transformateur est plus aisé à utiliser qu'une pluralité de détecteurs acoustiques séparés.

Mais dans un but de simplification des calculs, il a été considéré que le temps mis par l'onde acoustique générée par la source de décharge partielle était le même pour atteindre chacun des trois détecteurs acoustiques qui sont en fait très proches les uns des autres. La précision de la mesure est médiocre. Pour améliorer un peu la précision de la localisation de la source de décharge partielle, plusieurs mesures simultanées avec plusieurs dispositifs placés en divers lieux de l'enceinte peuvent être faites. Mais le dispositif de mesure devient vite très encombrant. En variante, les mesures peuvent être faites successivement en déplaçant en plusieurs lieux de l'enceinte le support. Mais alors un cycle de mesures prend du temps et la précision de la localisation reste médiocre car les signaux détectés ne proviennent pas forcément de la même source de décharge partielle.

Bien que l'approximation décrite dans le paragraphe précédent simplifie les calculs, elle réduit la précision de la localisation.

La configuration décrite dans le brevet [3] nécessite l'usage de détecteurs acoustiques sur une même surface de l'enceinte du transformateur et cette configuration nécessite aussi un arrangement de détecteurs acoustiques proches les uns des autres, la distance entre les détecteurs acoustiques est plus petite que la distance entre chacun des détecteurs acoustiques et la source de décharge partielle recherchée.

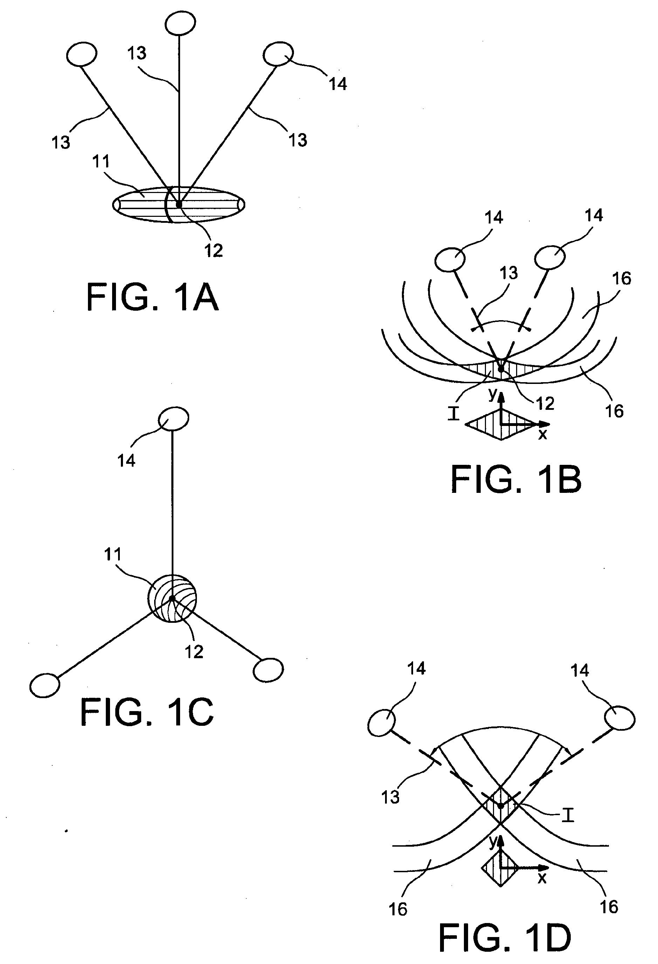

Comme représenté sur les figures 1A, 1B, 1C, 1D la zone d'incertitude 11 (ou zone d'erreur) dans laquelle se trouve la source de décharge partielle 12 est moindre quand les droites 13 reliant chacun des détecteurs acoustiques 14 d'une paire et la source de décharge partielle 12 forment un angle d'environ 90°. Or, cela n'est pas possible avec l'arrangement décrit dans le brevet [3]. Sur la figure 1A, les trois détecteurs acoustiques 14, vus de la source de décharge partielle 12, sont proches les uns des autres et les droites 13 forment deux à deux un angle bien inférieur à 90°. La zone d'incertitude 11 est grande et prend la forme sensiblement d'un ellipsoïde. Cette zone d'incertitude 11 correspond sensiblement à l'intersection I, dans un plan y, z contenant la source de décharge partielle 12, entre les gammes d'incertitudes 16 dans ce plan, associées à chacun des détecteurs acoustiques 14. Cette intersection I est représentée sur la figure 1B pour deux des détecteurs acoustiques 14. Les figures 1C, 1D sont similaires aux figures 1A, 1B à l'exception du fait que maintenant les détecteurs acoustiques 14 vus de la source de décharge partielle 12 sont éloignés les uns des autres. L'intersection I est beaucoup plus petite que dans le cas précédent.

Pour avoir une possibilité de localisation précise de la source de décharge partielle, le conseil donné dans l'élément 8.0 de la norme - IEEE PC57.127/D2.0, septembre 03, "Draft Guide for the Detection and Location of Acoustic Emission from Partial Discharges in Oil-Immersed Power Transformers and Reactors" est d'utiliser un minimum de six détecteurs, de préférence neuf détecteurs (trois détecteurs par phase pour un appareil comme un transformateur). L'arrangement de trois détecteurs suggéré dans le brevet [3] n'est donc pas suffisant. On doit donc utiliser plusieurs arrangements de trois détecteurs, ce qui rend l'utilisation de cette méthode très compliquée. Cela est contraire au but fondamental du brevet [3] qui est de simplifier le mode d'utilisation et le calcul.

Des éléments complémentaires peuvent être trouvés dans les documents [4] à [10] dont les références sont également précisées à la fin de la description en ce qui concerne les types de dispositifs utilisés, plus particulièrement, le document WO 96/18112 décrit un procédé et dispositif pour localiser les décharges partielles dans un appareil électrique à haute tension.

## EXPOSÉ DE L'INVENTION

La présente invention a justement comme but de proposer un procédé de détection et de localisation de sources de décharges partielles dans un appareil électrique qui ne présente pas les inconvénients mentionnés ci dessus.

Un but est en particulier de permettre une localisation de la décharge partielle avec une grande précision. Une connaissance précise du lieu d'origine de décharges partielles fait gagner du temps et elle est de ce fait plus économique, car elle permet alors un diagnostic plus rapide du disfonctionnement de l'appareil et l'intervention à réaliser pour la remise en état de l'appareil en est facilitée.

Un autre but de l'invention est de permettre la mise en oeuvre d'une localisation simple, qui s'adapte à tout type d'appareil électrique. De plus un autre but de l'invention est de permettre une localisation rapide.

Pour y parvenir, la présente invention propose d'utiliser des groupes de détecteurs acoustiques et de vérifier que des détecteurs de ces groupes matérialisent des triangles qui satisfont à des conditions sur leurs angles d'une part et de vérifier d'autre part que des détecteurs de ces groupes associés à une position approchée calculée de la source de décharge partielle matérialisent des triangles qui satisfont aux conditions sur leurs angles.

Plus précisément, la présente invention est un procédé de détection et de localisation d'une source de décharge partielle dans un appareil électrique placé dans une enceinte contenant un fluide acoustiquement conducteur. Il comporte les étapes suivantes :

- positionnement de N détecteurs acoustiques, aptes à détecter une onde acoustique émise par la source de décharge partielle, contre l'extérieur de l'enceinte et acquisition de la position des N détecteurs acoustiques ;
- définition, parmi les N détecteurs acoustiques, de P groupes de détecteurs acoustiques avec $P = Z!/(3!(Z-3)!)$, chaque groupe comportant au moins trois détecteurs et Z étant égal à N étant égal à 3 ou plus, ou quatre détecteurs et Z étant égal à N-1 étant égal à 3 ou plus;
- réalisation d'une première vérification pour s'assurer que chaque groupe est exempt de triangle, à sommets matérialisés par trois détecteurs acoustiques, dont au moins un angle est hors d'une plage d'angles prédéterminée, dans le cas contraire élimination du groupe ;

- pour chaque groupe non éliminé après la première vérification, calcul d'une position approchée de la source de décharge partielle à partir de la position des détecteurs acoustiques du groupe et de l'instant de réception de l'onde acoustique émise par la source de décharge partielle par chacun des détecteurs du groupe ;
- réalisation d'une seconde vérification pour s'assurer que chaque groupe, non éliminé après la première vérification, est exempt de triangle, à sommets matérialisés par deux des détecteurs du groupe et par la position approchée de la source de décharge partielle, dont moins un angle est hors de la plage prédéterminée, dans le cas contraire élimination du groupe ;
- calcul de la position recherchée de la source de décharge partielle, en effectuant une moyenne des positions approchées calculées pour tout ou partie des groupes non éliminés après la seconde vérification.

La plage d'angles peut s'étendre avantageusement entre 30° et 151° bornes incluses.

Pour améliorer la précision de la localisation, le procédé peut comprendre, en outre, les étapes suivantes :

- acquisition des dimensions de l'enceinte ;
- réalisation d'une vérification additionnelle pour s'assurer que la position approchée de la source de décharge partielle, calculée pour chacun des groupes non éliminés après la seconde vérification, se trouve à l'intérieur de l'enceinte de l'appareil, dans le cas contraire élimination du groupe.

La vérification additionnelle peut se faire avec une tolérance prédéterminée.

Dans ce cas, la moyenne se fait avec les positions approchées calculées pour tout ou partie des groupes non éliminés après la vérification additionnelle.

Toujours dans le même but, le procédé peut comprendre en outre l'étape suivante .

- réalisation d'une vérification supplémentaire visant à éliminer au moins un détecteur acoustique conduisant à au moins une position approchée considérée comme aberrante.

Cette vérification peut se faire en deux temps. Ils consistent :

a°) à repérer parmi les positions approchées de la source de décharge partielle, calculées pour chacun des groupes non éliminés après la vérification réalisée en dernier, au moins une position approchée extrême ;
b°) à identifier au moins un détecteur acoustique à l'origine de cette position approchée extrême et à éliminer tout groupe de détecteurs acoustiques comportant le détecteur acoustique identifié ;
à répéter les étapes a°) et b°) tant qu'un paramètre de probabilité d'erreur sphérique SEP, calculé à partir des positions approchées de la source de décharge partielle pour les groupes non éliminés, est supérieur à une valeur prédéterminée.

Le paramètre SEP est défini par SEP = 0,513 $(\sigma_x + \sigma_y + \sigma_z)$ avec $\sigma_x$ écart-type des abscisses des positions approchées de la source de décharge partielle, $\sigma_y$ écart-type des ordonnées des positions approchées de la source de décharge partielle, $\sigma_z$ écart-type des cotes des positions approchées de la source de décharge partielle.

On peut envisager, que le procédé comporte une étape d'application de M détecteurs acoustiques sur la paroi externe de l'enceinte de l'appareil électrique et de sélection, parmi les M détecteurs acoustiques, des N détecteurs acoustiques aptes à détecter une onde acoustique émise par la source de décharge partielle.

Lorsque Z=N, un groupe est formé d'un triplet de détecteurs acoustiques, le calcul des positions approchées se faisant par triangulation en résolvant le système d'équations suivant :

$$(x_{Gi}-xi)^2 + (y_{Gi}-yi)^2 + (z_{Gi}-zi)^2 - v^2(ti-t0)^2 = 0$$

$$(x_{Gi}-xj)^2 + (y_{Gi}-yj)^2 + (z_{Gi}-zj)^2 - v^2(tj-t0)^2 = 0$$

$$(x_{Gi}-xk)^2 + (y_{Gi}-yk)^2 + (z_{Gi}-zk)^2 - v^2(tk-t0)^2 = 0,$$

dans lequel $x_{Gi}$, $y_{Gi}$, $z_{Gi}$ représentent la position approchée de la source de décharge partielle, (xi, yi, zi), (xj, yj, zj), (xk, yk, zk) la position des détecteurs acoustiques du triplet, t0 un instant d'émission d'une décharge partielle générée par la source et ti, tj, tk les instants de réception de l'onde acoustique émise par la décharge partielle par chacun des détecteurs acoustiques du triplet, v la vitesse de l'onde acoustique dans le fluide.

L'instant d'émission de la décharge partielle peut être mesuré par des moyens électriques tels un détecteur de type antenne qui coopère avec l'enceinte.

Lorsque Z = N - 1, un groupe est formé d'un quadruplet de détecteurs acoustiques incluant parmi les quatre détecteurs acoustiques, un détecteur acoustique servant de référence temporelle, le calcul des positions approchées se faisant par triangulation en résolvant le système d'équations suivant :

$$\sqrt{(x_{Gj} - xj)^2 + (y_{Gj} - yj)^2 + (z_{Gj} - zj)^2} -$$

$$\sqrt{(x_{Gj} - xi)^2 + (y_{Gj} - yi)^2 + (z_{Gj} - zi)^2} - v(tj - ti) = 0$$

$$\sqrt{(x_{Gj} - xk)^2 + (y_{Gj} - yk)^2 + (z_{Gj} - zk)^2} -$$

$$\sqrt{(x_{Gj} - xi)^2 + (y_{Gj} - yi)^2 + (z_{Gj} - zi)^2} - v(tk - ti) = 0$$

$$\sqrt{(x_{Gj} - xl)^2 + (y_{Gj} - yl)^2 + (z_{Gj} - zl)^2} -$$

$$\sqrt{(x_{Gj} - xi)^2 + (y_{Gj} - yi)^2 + (z_{Gj} - zi)^2} - v(tl - ti) = 0 \,,$$

dans lequel $x_{Gj}$, $y_{Gj}$, $z_{Gj}$ représentent la position approchée de la source de décharge partielle, (xi, yi, zi), (xj, yj, zj), (xk, yk, zk), (xl, yl, zl) la position des quatre détecteurs acoustiques du quadruplet, ti, tj, tk, tl les instants de réception de l'onde acoustique émise par la décharge partielle par chacun des détecteurs acoustiques du quadruplet, v la vitesse de l'onde acoustique dans le fluide.

Ainsi on peut localiser avec précision, rapidement, simplement et avec souplesse la source de décharge partielle sans à avoir à utiliser des agencements figés de détecteurs et sans faire des simplifications ou des suppositions au niveau des mesures données par ces détecteurs, ces simplifications et ces suppositions apportant des imprécisions.

**BRÈVE DESCRIPTION DES DESSINS**

La présente invention sera mieux comprise à la lecture de la description d'exemples de réalisation donnés, à titre purement indicatif et nullement limitatif, en faisant référence aux dessins annexés sur lesquels :

les figures 1A à 1D (déjà décrites) permettent de comprendre pourquoi la zone d'incertitude sur la position de la source de décharge partielle est importante lorsque la distance séparant deux détecteurs acoustiques est plus petite que la distance séparant chacun de ces détecteurs acoustiques de la source de décharge partielle ;
la figure 2 montre un exemple d'appareillage pour la mise en oeuvre du procédé selon l'invention ;
la figure 3 montre un exemple de détecteur électrique de type antenne et des moyens d'acquisition et de traitement du signal délivré par le détecteur de type antenne ;
la figure 4A représente, sous forme d'organigramme, un premier exemple du procédé selon l'invention et la figure 4B le détail du bloc 43 représenté sur la figure 4A;
la figure 5 illustre sous forme d'exemple un autre exemple du procédé selon l'invention :
la figure 6 illustre la démonstration conduisant au choix de la plage d'angles ;
la figure 7 donne des positions approchées de la source de décharge partielle vues de vingt groupes de détecteurs acoustiques ainsi que le paramètre SEP;
les figures 8A, 8B, 8C illustrent respectivement la répartition des abscisses, des ordonnées et des cotes des positions approchées vues des vingt groupes de détecteurs acoustiques ;
la figure 9 donne des positions approchées de la source de décharge partielle vues des groupes de détecteurs de la figure 7 qui ne comprennent pas le détecteur n°52, ainsi que le paramètre SEP ;

la figure 10 donne des positions approchées de la source de décharge partielle vues des groupes de détecteurs de la figure 9 qui ne comprennent pas le détecteur n°1, ainsi que le paramètre SEP ;

la figure 11 est un tableau de comparaison entre des positions de sources de décharge partielle simulées et expérimentales obtenues par les deux variantes du procédé selon l'invention et par un procédé classique.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

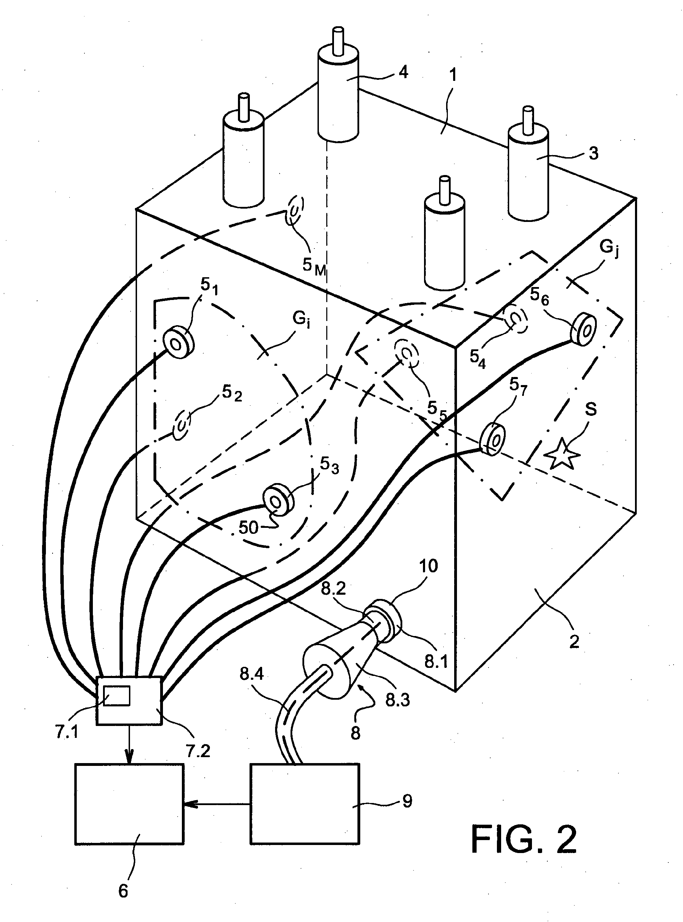

On va se référer à la figure 2 qui montre un exemple d'appareillage utilisé pour la mise en oeuvre d'un procédé selon l'invention pour la détection et la localisation d'une source de décharge partielle dans un appareil électrique. On suppose que cet appareil électrique est un transformateur haute tension sous tension. Le transformateur comprend des enroulements et des noyaux qui ne sont pas représentés pour ne pas surcharger la figure et il se trouve à l'intérieur d'une enceinte 1. Cette enceinte 1 est réalisée dans un matériau conducteur acoustiquement tel de la tôle d'acier.

Cette enceinte 1 contient, en plus de l'appareil électrique, un milieu 2 acoustiquement conducteur. Ce milieu 2 acoustiquement conducteur peut être de l'huile ou un autre fluide. Ce milieu 2 sert à isoler électriquement les conducteurs des enroulements entre eux. Il peut également servir pour les refroidissements desdits enroulements.

L'enceinte 1 est équipée de traversées 3 à haute tension et de traversées 4 à basse tension.

L'appareillage de détection et de localisation d'une source de décharge partielle S comporte plusieurs détecteurs acoustiques $5_1$, $5_2$, $5_3$, ... $5_M$ répartis sur la paroi externe l'enceinte 1. Ces détecteurs acoustiques $5_1$, $5_2$, $5_3$, ... $5_M$ peuvent être montés sur un support 50 et maintenus contre la paroi externe de l'enceinte 1 à l'aide d'au moins un aimant (non représenté) solidaire du support 50. Les détecteurs acoustiques $5_1$, $5_2$, $5_3$, ... $5_M$ sont destinés à détecter des ondes acoustiques générées par la source de décharge partielle S et qui se propagent dans le milieu 2 acoustiquement conducteur. Lorsque les détecteurs acoustiques $5_1$, $5_2$, $5_3$, ... $5_M$ détectent une onde acoustique, ils délivrent un signal. Ces détecteurs acoustiques $5_1$, $5_2$, $5_3$, ... $5_M$ peuvent être par exemple de type piézoélectrique et être sensibles à des fréquences comprises entre 20 kHz et 300kHz et plus particulièrement entre 60 kHz et 200 kHz.

Les détecteurs acoustiques $5_1$, $5_2$, $5_3$, ... $5_M$ sont connectés électriquement d'une part à des moyens d'alimentation en énergie 7.1 et d'autre part à des moyens d'acquisition et de traitement 7.2 des signaux délivrés par eux. Le traitement subi par les signaux délivrés par les détecteurs acoustiques $5_1$, $5_2$, $5_3$, ... $5_M$ comprend par exemple un filtrage et une conversion analogique numérique. Dans ce mode de réalisation, l'appareillage comporte également des moyens de détection électrique 8 d'une onde haute fréquence ou ultra haute fréquence émise par la source de décharge partielle S. Il peut s'agir d'un détecteur de type antenne 8 tel que décrit dans la demande de brevet français déposée au nom d'ALSTOM le 27 février 2003 sous le numéro 0302388 (FR2851852). Ces moyens de détection électrique 8 sont destinés à détecter l'instant d'émission t0 d'une décharge partielle émise par la source S. Ils servent de déclencheur pour la détection acoustique, car dès qu'une décharge partielle a été captée électriquement, les détecteurs acoustiques $5_1$, $5_2$, $5_3$, ... $5_M$ sont activés. On est alors bien sûr que l'onde acoustique qu'ils vont détecter provient de la source de décharge partielle S.

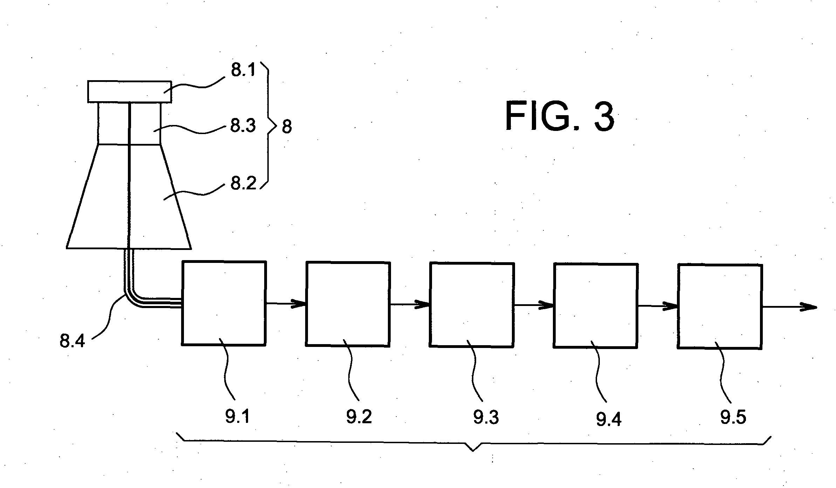

Ce détecteur de type antenne 8 comporte deux électrodes 8.1, 8.2, séparées par un résonateur diélectrique 8.3. Le détail du détecteur de type antenne 8 est illustré sur la figure 3. Ce détecteur de type antenne 8 est destiné à détecter des ondes hautes fréquences ou ultra hautes fréquences générées simultanément par la source de décharge partielle S. Ces ondes hautes fréquences ou ultra hautes fréquences se propagent à la vitesse de la lumière et leur détection permet de déterminer l'instant d'émission t0 d'une décharge partielle. En réponse à ces ondes, le détecteur de type antenne 8 délivre un signal d'antenne. Le détecteur de type antenne 8 est relié par un câble coaxial 8.4 à des moyens d'acquisition et de traitement 9 du signal d'antenne.

Le détecteur de type antenne 8 est placé dans un logement 10 rapporté sur l'enceinte 1. Ce logement 10 se situe au niveau d'une vanne de vidange généralement prévue en partie basse de l'enceinte 1 pour permettre de retirer le fluide diélectrique ou de faire des tests.

Au lieu d'utiliser un détecteur de type antenne, les moyens de détection électrique pourraient utiliser un dispositif de mesure électrique placé au niveau d'une prise capacitive se trouvant à la base des traversées électriques 3 ou 4 ou bien une sonde de courant placée autour d'un câble (non représenté) qui connecte la borne neutre du transformateur à la terre ou autour d'un câble (non représenté) qui connecte la cuve d'appareil à la terre. Ces moyens de détection électrique mesurent des pics de tension électrique engendrés par les décharges partielles.

On se réfère maintenant à la figure 3 qui montre de manière schématique le détecteur de type antenne 8 et les moyens d'acquisition et de traitement 9 du signal délivré par le détecteur de type antenne 8. Les moyens d'acquisition et de traitement 9 du signal d'antenne peuvent comprendre connectés en cascade à partir du détecteur de type antenne 8, un convertisseur abaisseur de fréquence 9.1, un amplificateur 9.2, un redresseur demi onde 9.3 et un circuit détecteur d'enveloppe 9.4. Le convertisseur abaisseur de fréquence 9.1 reçoit le signal d'antenne et décale sa fréquence d'une gamme de haute fréquence (ou ultra haute fréquence) par exemple comprise entre 200 MHz et 1500 MHz vers une gamme de basse fréquence par exemple comprise entre 200 kHz et 800 kHz. L'amplificateur 9.2 amplifie le signal délivré par le convertisseur abaisseur de fréquence 9.1. Le redresseur demi onde 9.3 élimine la partie négative du signal délivré par l'amplificateur 9.2. Le circuit détecteur d'enveloppe 9.4 extrait l'enveloppe du signal délivré par le redresseur demi-onde 9.3.

Les signaux délivrés par le circuit détecteur d'enveloppe 9.4 sont ensuite convertis en signaux numériques dans un convertisseur analogique-numérique 9.5 avant de pouvoir être utilisés en tant qu'instant d'émission t0 d'une décharge partielle comme on le verra ultérieurement.

Les signaux numériques issus des détecteurs acoustiques $5_1$, $5_2$, $5_3$, ... $5_M$ et les signaux numériques issus du détecteur de type antenne 8 sont traités par le procédé objet de l'invention dans des moyens de calcul 6, par exemple un calculateur, inclus dans l'appareillage ou un ordinateur avec lequel coopère l'appareillage. Le calculateur ou l'ordinateur contient un logiciel approprié pour la mise en oeuvre du procédé selon l'invention.

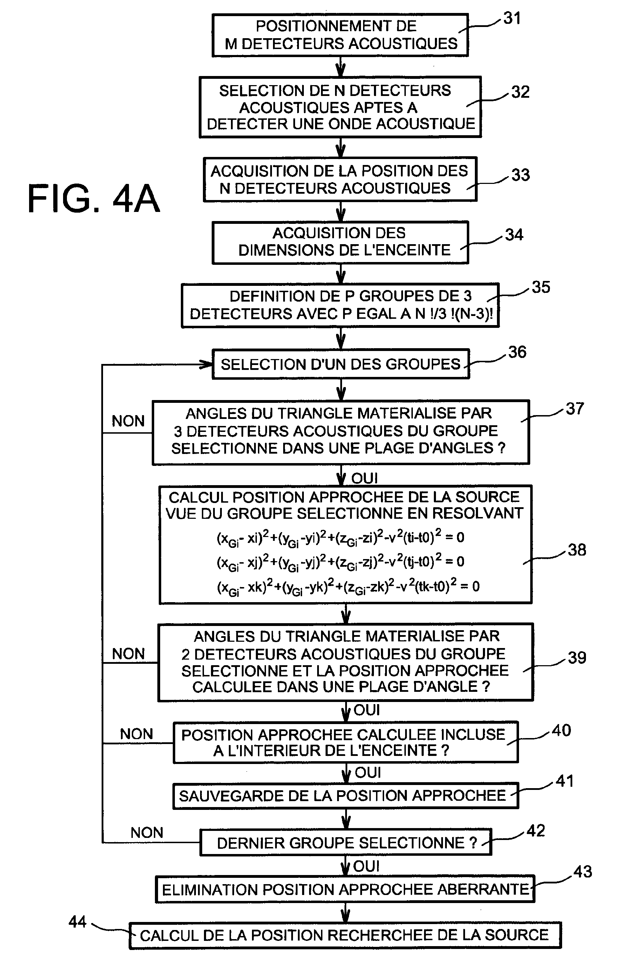

On va maintenant décrire une première variante du procédé selon l'invention en se référant à l'organigramme de la figure 4A en liaison avec la figure 2.

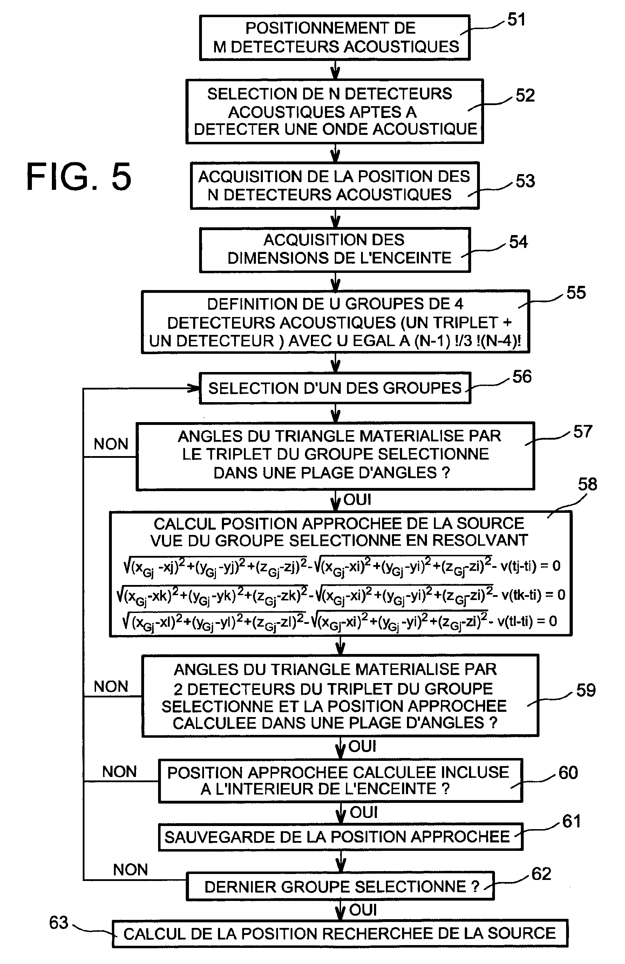

Dans une seconde variante décrite à la figure 5, la détection de type électrique n'est plus nécessaire et seuls des détecteurs acoustiques sont utilisés. L'appareillage utilisé n'est pas spécifiquement illustré pour cette seconde variante. En se référant à la figure 2, il suffit de faire abstraction des moyens de détection électrique 8 et des moyens d'acquisition et de traitement 9 du signal d'antenne.

Tout d'abord considérons que M détecteurs acoustiques $5_1$, $5_2$, $5_3$, ... $5_M$ ont été positionnés contre la paroi externe de l'enceinte de l'appareil électrique (bloc 31).

On peut d'abord sélectionner parmi ces M détecteurs acoustiques N détecteurs acoustiques qui sont aptes à détecter des ondes acoustiques en provenance d'une source de décharge partielle à localiser (bloc 32). N est inférieur ou égal à M. Selon la position de la source de décharge acoustique S dans l'enceinte 1, il peut arriver qu'au moins un détecteur acoustique $5_M$ par exemple ne soit pas apte à détecter des ondes acoustiques émises par cette source S. Ce détecteur peut être trop éloigné de la source de décharge partielle S ou en être masqués par des écrans dans la cuve du transformateur.

La position de chacun des N détecteurs acoustiques est acquise (bloc 33), elle est mémorisée dans une mémoire des moyens de calcul. En variante, cette étape d'acquisition aurait pu concerner les M détecteurs acoustiques avant de sélectionner les N détecteurs acoustiques utilisables.

La position des détecteurs acoustiques est donnée par les coordonnées xi, yi, zi (avec i compris entre 1 et N) de chaque détecteur acoustique dans un repère orthonormé dont l'origine est un point de référence de l'enceinte 1 qui est généralement parallélépipédique. Il peut s'agir par exemple d'un coin de l'enceinte 1.

On peut également acquérir les dimensions de l'enceinte (bloc 34), celles-ci sont également mémorisées dans une mémoire des moyens de calcul.

Dans le bloc 35, on définit P groupes G1 à GP de 3 détecteurs acoustiques. Ces groupes sont des triplets. P est un entier égal à N !/(3 !(N-3) !). P correspond au nombre de combinaisons de trois détecteurs acoustiques pris dans un ensemble de N détecteurs acoustiques.

Dans le bloc 36, on va sélectionner successivement chacun des P groupes ou triplets.

Dans le bloc 37, on effectue une première vérification concernant un triplet sélectionné Gi (i compris entre 1 et P). Il s'agit de vérifier que le triangle délimité par les détecteurs du triplet sélectionné a tous ses angles qui remplissent une condition prédéterminée, à savoir que ses angles sont compris dans une plage d'angles prédéterminée. Cette plage d'angles s'étend préférentiellement entre 30° et 151° bornes incluses.

Si le triplet sélectionné ne satisfait pas à cette condition d'angles, il est éliminé. On sélectionne ensuite un autre triplet (au bloc 36) pour lui faire subir la première vérification. Tous les triplets subissent ces premières vérifications.

Cette première vérification se fait donc successivement pour chacun des P triplets. Après la première vérification, on suppose qu'il ne reste plus que Q triplets G1 à GQ à considérer et que P-Q triplets ont été éliminés.

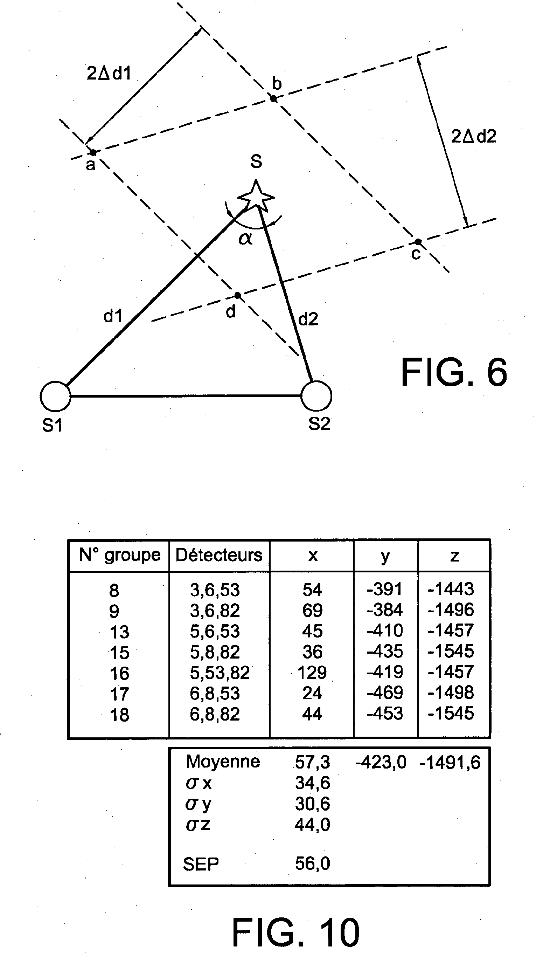

On va expliquer maintenant la signification de cette condition d'angles. On se reporte à la figure 6.

On a représenté un premier détecteur acoustique S1 et un second détecteur acoustique S2 et une source de décharge partielle S. La paroi de l'enceinte de l'appareil électrique n'est pas visible pour ne pas surcharger la figure. La distance entre le premier détecteur acoustique S1 et la source de décharge partielle S vaut d1, et la distance entre le second détecteur acoustique S2 et la source de décharge partielle S vaut d2. Ces distances d1, d2 ne peuvent être connues qu'avec une certaine erreur $\pm\Delta d1$, $\pm\Delta d2$ respectivement. Une zone d'erreur est matérialisée par le parallélogramme a, b, c, d.

Lorsque $\Delta d1 = \Delta d2 = \Delta d$, comme sur la figure 6, le parallélogramme a, b, c, d devient un losange.

D'après les règles de trigonométrie,

$$ac= 2\ \Delta d/\cos\ (\pi/2 - \alpha/2) \qquad \text{équation (1)}$$

et

$$bd= 2\ \Delta d/\sin\ (\pi/2 - \alpha/2) \qquad \text{équation (2)}$$

Imposons une valeur maximale $\Delta 1$ pour ac et bd, il vient ac $< \Delta 1$ et bd $< \Delta 1$.

A partir des équations (1) et (2) on obtient les inégalités suivantes .

$$\Delta d/\Delta l\ <\ \cos(\pi/2 - \alpha/2) \qquad \text{équation (3)}$$

$$\Delta d/\Delta l\ <\ \sin(\pi/2 - \alpha/2) \qquad \text{équation (4)}$$

Soit :

$$\alpha\ >\ 2 \arcsin\ (\Delta d/\Delta l)$$

$$2 \arcsin\ (\Delta d/\Delta l)\ <\ 2 \arccos\ (\Delta d/\Delta l)$$

et donc

$$2 \arcsin\ (\Delta d/\Delta l)<\ \alpha\ <\ 2 \arccos\ (\Delta d/\Delta l)$$

si

$$\alpha 0\ =\ 2\ \arcsin\ (\Delta d/\Delta l)$$

et si

$$\alpha 1\ =\ 2\ \arccos\ (\Delta d/\Delta l)\ \text{alors}\ \alpha 0<\ \alpha\ <\ \alpha 1$$

Si $\Delta 1 = 4\ \Delta d$ qui est un choix préférentiel alors $\alpha 0=30°$ et $\alpha 1=151°$
et donc $30°< \alpha < 151°$

Si par exemple d1= d2 = 1, 5 $\pm$ 0, 015 m alors $\Delta 1=$ 0, 06 m.

La précision de la localisation est largement dépendante de la première valeur de l'angle ($\alpha 0$) . Si $\alpha 0 < 30°$, la précision est réduite et si $\alpha 0 > 30°$ la précision est meilleure. La deuxième valeur de l'angle ($\alpha 1$) doit préférablement être supérieur à 90°. Mais, si on choisit l'angle $\alpha 0 > 30°$, le nombre des points calculés est considérablement réduit et cela peut rendre la localisation difficile. De la même manière, si on choisit $\Delta 1 = 2\ \Delta d$ on obtient $\alpha 0 = 60°$ alors le problème précédent s'applique aussi ici.

Lorsqu'un triplet vérifie la condition d'angles, c'est-à-dire lorsque tous les angles du triangle matérialisé par les détecteurs acoustiques sont compris dans la plage d'angles bornes incluses, on calcule au bloc 38 une position approchée $(x_{Gi}, y_{Gi}, z_{Gi})$ de la source de décharge partielle S, vue des détecteurs du triplet Gi sélectionné, à partir de la position des détecteurs acoustiques du triplet Gi et à partir des signaux délivrés par le détecteur de type antenne 8. Plus précisément, il s'agit de résoudre par optimisation le système d'équations à trois inconnues suivant :

$$(x_{Gi}-xi)^2+(y_{Gi}-yi)^2+(z_{Gi}-zi)^2-v^2(ti-t0)^2 = 0$$

$$(x_{Gi}-xj)^2+(y_{Gi}-yj)^2+(z_{Gi}-zj)^2-v^2(tj-t0)^2 = 0$$

$$(x_{Gi}-xk)^2 + (y_{Gi}-yk)^2+(z_{Gi}-zk)^2-v^2(tk-t0)^2 = 0$$

(xi, yi, zi), (xj, yj, zj), (xk, yk, zk) représentent la position des trois détecteurs acoustiques du groupe Gi sélectionné, v est la vitesse de l'onde acoustique dans le fluide, t0 représente t0 un instant d'émission d'une décharge partielle générée par la source de décharge partielle S et ti, tj, tk les instants de réception de l'onde acoustique émise par la décharge partielle par chacun des détecteurs acoustiques du groupe Gi.

Au bloc 39, on réalise une seconde vérification pour s'assurer que chacun des Q triplets G1 à GQ, c'est-à-dire les triplets non éliminés à l'issue de la première vérification, est exempt de triangle, à sommets matérialisés par deux détecteurs acoustiques du triplet sur les trois et par la position approchée de la source de décharge partielle calculée précédemment, ayant au moins un angle hors de la même plage d'angles prédéterminée. Si un triplet ne satisfait pas à cette condition d'angles, il est éliminé. A l'issue de cette étape, lorsque les Q triplets non éliminés à l'issue de la première vérification ont subi la seconde vérification, on dispose de R triplets avec R ≤ Q.

A ce stade, on peut sauvegarder les positions approchées de la source de décharge partielle S calculées à partir des R triplets non éliminés à l'issue de la seconde vérification.

Il est toutefois préférable de réaliser, au préalable au bloc 40, une vérification additionnelle qui consiste à s'assurer que les positions approchées de la source de décharge partielle S calculées au bloc 38 pour les R triplets non éliminés à l'issue de la seconde vérification sont bien incluses dans l'enceinte 1 de l'appareil électrique. Cette vérification additionnelle se fait par une comparaison avec les dimensions de l'enceinte acquises au bloc 34. On peut prévoir une certaine tolérance qui peut par exemple valoir environ 20 cm.

Un triplet Gi ayant conduit à une position de la source de décharge partielle S à l'extérieur de l'enceinte 1 est éliminé. A l'issue de cette vérification additionnelle, on dispose donc de T triplets de détecteurs acoustiques avec T ≤ R.

Cette vérification additionnelle améliore la précision de la localisation de la source de décharge partielle.

Dans ce cas, la sauvegarde (bloc 41) se fait avec les positions approchées de la source de décharge partielle S calculées à partir des T triplets non éliminés à l'issue de la vérification additionnelle. Les positions approchées sont mémorisées dans une mémoire des moyens de calcul.

Au bloc 42, on effectue une vérification pour se rendre compte si on arrive à la fin du calcul, c'est-à-dire que l'on recherche si le groupe analysé est le dernier groupe sélectionné, tous les autres ayant déjà été analysés.

Selon une variante avantageuse car conduisant à une plus grande précision de localisation, il est possible d'effectuer une vérification supplémentaire au bloc 43 sur l'ensemble des groupes non éliminés à l'issue de la vérification précédente. Il peut s'agir des T groupes non éliminés à l'issue de la vérification additionnelle (bloc 40) ou des R groupes non éliminés à l'issue de la seconde vérification (bloc 39) si la vérification additionnelle est omise. Cette vérification supplémentaire consiste à rechercher des positions approchées aberrantes et à éliminer des détecteurs acoustiques contribuant à ces positions approchées considérées comme aberrantes.

On suppose que l'étape du bloc 40 a eu lieu et qu'on est en présence de T groupes de triplets.

Cette vérification supplémentaire (bloc 43) peut consister en un traitement mathématique statistique et s'effectuer en deux temps.

Ces deux temps consistent :

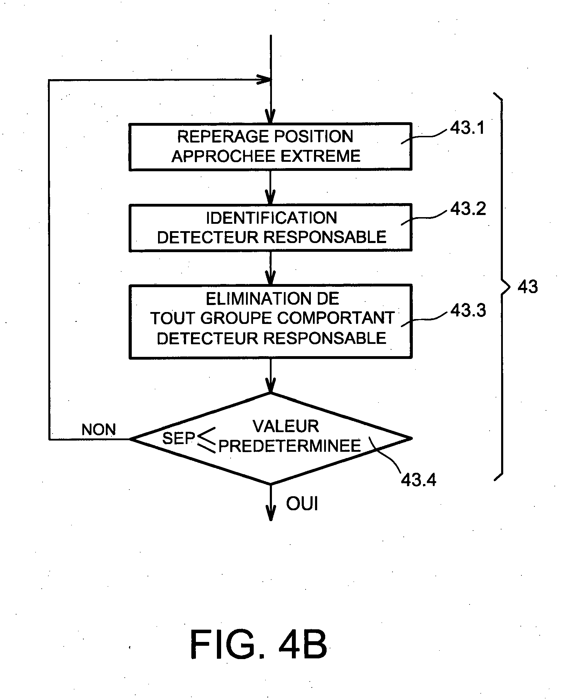

à repérer parmi les positions approchées de la source de décharge partielle, calculées pour chacun des groupes non éliminés après la vérification réalisée en dernier (ici pour chacun des T groupes), au moins une position approchée extrême (sous bloc 43.1 de la figure 4B); cette position est considérée comme aberrante.
à identifier au moins un détecteur acoustique à l'origine de cette position approchée extrême (sous bloc 43.2 de la figure 4B) et à éliminer tout groupe de détecteurs acoustiques comportant le détecteur acoustique identifié et responsable d'au moins une aberrance (sous bloc 43.3 de la figure 4B).

Ces deux étapes sont répétées successivement tant qu'un paramètre SEP appelé probabilité d'erreur sphérique (acronyme anglo-saxon de Spherical Error Probability), calculé à partir des positions approchées de la source de décharge partielle vues des groupes non éliminés et défini par SEP = 0,513 $(\sigma_x + \sigma_y + \sigma_z)$ avec $\sigma_x$ écart-type des abscisses des positions approchées de la source de décharge partielle, $\sigma_y$ écart-type des ordonnées des positions approchées de la source de décharge partielle, $\sigma_z$ écart-type des cotes des positions approchées de la source de décharge partielle, reste supérieur à une valeur prédéterminée (sous bloc 43.4 de la figure 4B).

Ce paramètre correspond à une mesure d'erreur qui exprime la précision globale en trois dimensions. Cette mesure d'erreur représente le rayon d'une sphère avec une probabilité de confiance de position de 50%.

Pour repérer la position approchée extrême, on peut par exemple tracer des graphes donnant la répartition des coordonnées (abscisse, ordonnée, cote), selon les axes x, y, z, des positions approchées de la source de décharge partielle vues de chacun desdits T groupes. On a au préalable donné un numéro d'ordre de 1 à T à chacun de ces T groupes.

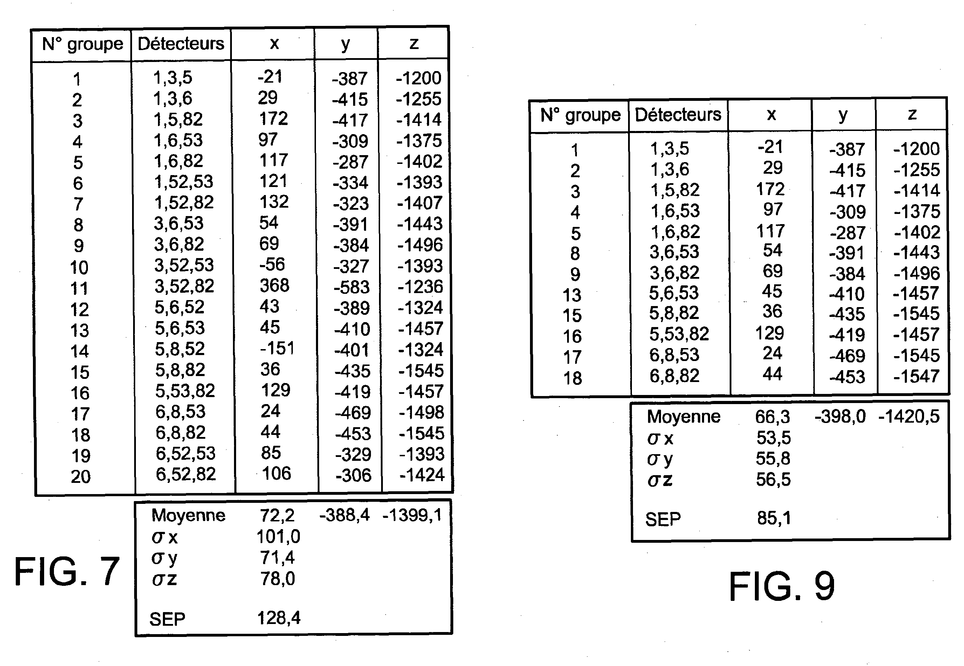

On peut se référer au tableau de la figure 7 qui donne l'abscisse (x), l'ordonnée (y) et la cote (z) en millimètres, dans un repère cartésien, des positions approchées de la source de décharge partielle vues de T=20 groupes de trois détecteurs acoustiques. Ces détecteurs acoustiques portent un numéro d'ordre et chacun des groupes également. Ces valeurs sont obtenues à partir d'un modèle d'enroulement de transformateur à 220 KV.

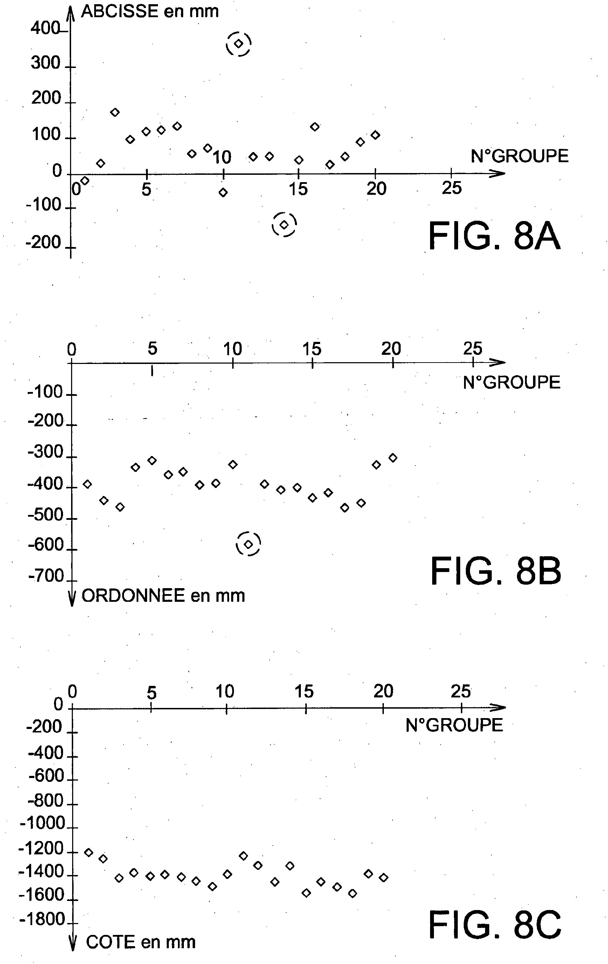

Sur la figure 8A, on a représenté avec des points la répartition des abscisses des positions approchées en fonction du numéro d'ordre des détecteurs acoustiques, sur la figure 8B, il s'agit des ordonnées et sur la figure 8C, il s'agit des cotes.

Il apparaît sur la figure 8A, que l'abscisse obtenue à partir du groupe n°11 et celle obtenue à partir du groupe n°14 sont aberrantes. Elles sont extrêmes, c'est à dire tout à fait excentrées par rapport au reste des autres abscisses qui sont relativement groupées. Sur la figure 8B, l'ordonnée obtenue à partir du groupe n°11 est également aberrante. Sur la figure 8C, les cotes sont bien groupées, il n'apparaît pas de point aberrant. Les points aberrants sont représentés encerclés.

Il ne s'agit que d'un exemple, dans d'autres cas, on pourra obtenir plus ou moins de points aberrants.

En analysant la composition des groupes n°11 (détecteurs n°3, 52 et 82) et n°14 (détecteurs n° 5, 8 et 52), on s'aperçoit que le détecteur acoustique n°52 est commun à ces deux groupes. Il serait donc la cause des aberrances détectées.

Si on élimine les groupes qui comportent le détecteur N°52, on va améliorer la précision des positions approchées.

La figure 9 représente un tableau similaire au tableau de la figure 7 mais dans lequel les groupes contenant le détecteur n°52 ont été éliminés. Il s'agit des groupes n°6, 7, 10, 11, 12, 14.

La précision de la mesure est améliorée comme le reflète le paramètre SEP qui passe de 128, 4 mm avant l'élimination des groupes contenant le détecteur n°52 (tableau de la figure 7) à 85, 1 mm après l'élimination des groupes contenant le détecteur n°52 (tableau de la figure 9).

On va continuer à effectuer les deux étapes suivantes tant que le paramètre SEP reste supérieur à une valeur prédéterminée.

A partir du tableau de la figure 9, on peut s'apercevoir que les groupes 1, 3, 4, 5 conduisent à des abscisses aberrantes. La cause en est le détecteur acoustique n°1 qui se retrouve dans chacun des groupes identifiés.

Si l'on élimine les groupes qui comportent ce détecteur acoustique n°1, on va améliorer la précision de la localisation de la source de décharge partielle.

Le tableau de la figure 10, illustre à la manière de celui de la figure 9, les positions approchées de la source de décharge partielle vues des groupes restants après l'élimination du détecteur acoustique n°1. Les groupes n°1, 2, 3, 4, 5 ont été éliminés. Il ne reste plus que U groupes de détecteurs acoustiques à considérer avec U<T. Le paramètre SEP vaut maintenant 56, 0 mm. On suppose que la valeur prédéterminée du paramètre SEP était de 56, 0 mm. Cette valeur a été atteinte. On arrête donc d'effectuer les deux étapes. Une amélioration de la précision d'environ 230% a été obtenue entre les résultats consignés dans le tableau de la figure 7 et ceux consignés dans le tableau de la figure 10.

On peut maintenant calculer la position recherchée de la source de décharge partielle. La dernière étape consiste à calculer la position recherchée de la source de décharge partielle à l'aide des positions approchées calculées pour tout ou partie des triplets non éliminés à l'issue de la dernière vérification effectuée (bloc 44) . Il s'agit soit de la seconde vérification, soit de la vérification additionnelle, soit de la vérification supplémentaire.

Ce calcul se fait par moyenne simple à partir des positions approchées sauvegardées. La position recherchée que l'on vient de calculer correspond ainsi au barycentre de l'ensemble des positions approchées utilisées dans le calcul de la moyenne.

On va maintenant en se référant à la figure 5 décrire une seconde variante du procédé selon l'invention.

Les blocs 51 à 54 sont similaires aux blocs 31 à 34 de la figure 4A. La principale différence se situe au niveau du bloc 55 qui diffère du bloc 35 de la figure 4A. De plus, la recherche des détecteurs conduisant à des positions approchées aberrantes n'a pas été faite. Il est bien sûr tout à fait possible de la réaliser de la même manière que décrit au bloc 43 de la figure 4A.

Dans ce bloc 55, on définit V groupes G1 à GV de 4 détecteurs acoustiques. Ces groupes sont des quadruplets. Un groupe Gj est composé d'un détecteur acoustique qui sert de référence temporelle par exemple $5_7$ associé à un triplet de détecteurs acoustiques $5_4$, $5_5$, $5_6$ qui servent de référence géométrique. Le détecteur acoustique qui sert de référence temporelle est l'un quelconque des N détecteurs acoustiques. Les trois détecteurs acoustiques qui servent de référence géométrique sont choisis parmi l'ensemble des N-1 détecteurs acoustiques restants. V est un entier égal à (N-1) ! /(3 !(N-4) !), il correspond au nombre de combinaisons de trois détecteurs acoustiques pris dans l'ensemble des N -1 détecteurs acoustiques restants.

Dans le bloc 56, on sélectionne un groupe Gj parmi les V groupes.

Ensuite au bloc 57, on effectue une première vérification concernant le groupe (quadruplet) sélectionné Gj (j compris entre 1 et V). Il s'agit de vérifier que les quatre triangles délimités par les quatre détecteurs acoustiques du quadruplet sélectionné ont tous leurs angles qui remplissent une condition prédéterminée, à savoir que ces angles sont compris dans une plage d'angles prédéterminée. Cette plage d'angles peut s'étendre préférentiellement entre 30° et 151° bornes incluses. Si le quadruplet sélectionné ne satisfait pas à cette condition d'angles, il est éliminé. On sélectionne ensuite un autre quadruplet pour lui faire subir la première vérification.

Cette première vérification se fait donc successivement pour chacun des V quadruplets. Après la première vérification, on suppose qu'il ne reste plus que W quadruplets G1 à GW à considérer avec W≤V et que V-W quadruplets ont été éliminés.

Lorsqu'un quadruplet vérifie la condition d'angles, c'est-à-dire lorsque tous les angles de chacun des quatre triangles matérialisés par trois détecteurs acoustiques du quadruplet sont compris dans la plage d'angles, on calcule au bloc 58 une position approchée ($x_{Gj}$, $y_{Gj}$, $z_{Gj}$) de la source de décharge partielle S, vue des détecteurs du quadruplet Gj sélectionné, à partir de la position des détecteurs acoustiques du quadruplet sélectionné et à partir des instants de réception de l'onde acoustique émise par la source de décharge partielle par chacun des détecteurs acoustiques du quadruplet.

Plus précisément, il s'agit de résoudre par optimisation le système d'équations à quatre inconnues suivant :

$$\sqrt{(x_{Gj} - xj)^2 + (y_{Gj} - yj)^2 + (z_{Gj} - zj)^2} -$$
$$\sqrt{(x_{Gj} - xi)^2 + (y_{Gj} - yi)^2 + (z_{Gj} - zi)^2} - v(tj - ti) = 0$$

$$\sqrt{(x_{Gj} - xk)^2 + (y_{Gj} - yk)^2 + (z_{Gj} - zk)^2} -$$
$$\sqrt{(x_{Gj} - xi)^2 + (y_{Gj} - yi)^2 + (z_{Gj} - zi)^2} - v(tk - ti) = 0$$

$$\sqrt{(x_{Gj} - xl)^2 + (y_{Gj} - yl)^2 + (z_{Gj} - zl)^2} -$$
$$\sqrt{(x_{Gj} - xi)^2 + (y_{Gj} - yi)^2 + (z_{Gj} - zi)^2} - v(tl - ti) = 0$$

(xi, yi, zi), (xj, yj, zj), (xk, yk, zk), (xl, yl, zl) représentent la position des quatre détecteurs acoustiques du quadruplet Gj sélectionné, v est la vitesse de l'onde acoustique dans le fluide, ti, tj, tk, tl les instants de réception d'une même onde acoustique émise par la décharge partielle par chacun des détecteurs acoustiques du quadruplet sélectionné Gj. On suppose dans cet exemple que le détecteur dont les coordonnées sont xi, yi, zi sert de référence temporelle. Un autre choix aurait été bien sûr possible.

Au bloc 59, on réalise une seconde vérification pour s'assurer que dans chacun des W quadruplets G1 à GW, c'est-à-dire les quadruplets non éliminés à l'issue de la première vérification, les six triangles, à sommets matérialisés par deux des détecteurs du quadruplet et par la position approchée de la source de décharge partielle calculée précédemment, ont tous leurs angles dans la plage d'angles prédéterminée.

Si un quadruplet ne satisfait pas à cette condition d'angles, il est éliminé. A l'issue de cette étape, lorsque les W quadruplets non éliminés à l'issue de la première vérification ont subi la seconde vérification, on dispose de X quadruplets avec X ≤ W.

A ce stade, on peut sauvegarder dans une mémoire des moyens de calcul, les positions approchées de la source de décharge partielle S calculées à partir des X quadruplets non éliminés à l'issue de la seconde vérification.

Il est toutefois préférable de réaliser, au préalable, une vérification additionnelle qui consiste à s'assurer que les positions approchées de la source de décharge partielle, calculées au bloc 60 pour les X quadruplets non éliminés à l'issue de la seconde vérification sont bien incluses dans l'enceinte 1 de l'appareil électrique. Cette vérification peut se faire par une comparaison avec les dimensions de l'enceinte acquise au bloc 54. On peut prévoir une certaine tolérance comme mentionné plus haut.

Un quadruplet Gj ayant conduit à une position de la source de décharge partielle à l'extérieur de l'enceinte est éliminé. A l'issue de cette vérification additionnelle, on dispose donc de Y quadruplets de détecteurs acoustiques avec $Y \leq X$.

Cette vérification additionnelle améliore la précision de la localisation de la source de décharge partielle.

Dans ce cas, la sauvegarde se fait au bloc 61, avec les positions approchées de la source de décharge partielle calculées à partir des Y quadruplets non éliminés à l'issue de la vérification additionnelle.

Elle pourrait concerner les positions approchées de la source de décharge calculées à partir des X quadruplets non éliminés à l'issue de la seconde vérification si la vérification additionnelle est omise.

Au bloc 62, on vérifie qu'on arrive à la fin du calcul, c'est-à-dire qu'on est en présence du dernier groupe sélectionné, tous les autres ayant été analysés préalablement.

La dernière étape est de calculer la position recherchée de la source de décharge partielle à l'aide des positions approchées calculées pour tout ou partie des quadruplets non éliminés à l'issue de la seconde vérification ou de la vérification additionnelle si elle a eu lieu. Ce calcul peut se faire comme précédemment à partir des positions approchées mises en mémoire par moyenne simple.

Si on prévoit de réaliser la vérification supplémentaire décrite au bloc 43 de la figure 4A, elle a lieu avant le calcul de la position recherchée de la source de décharge partielle.

On suppose que dans cet exemple, on calcule, au bloc 63, la position recherchée de la source de décharge partielle par moyenne simple à partir des positions approchées des Y groupes de détecteurs acoustiques non éliminés à l'issu de la vérification supplémentaire.

Cette seconde variante conduit à une meilleure précision que celle obtenue avec la première variante car on n'introduit pas d'imprécision induite par la détection de l'onde haute fréquence ou ultra haute fréquence.

La vérification additionnelle et la vérification supplémentaire augmentent encore la précision de la localisation.

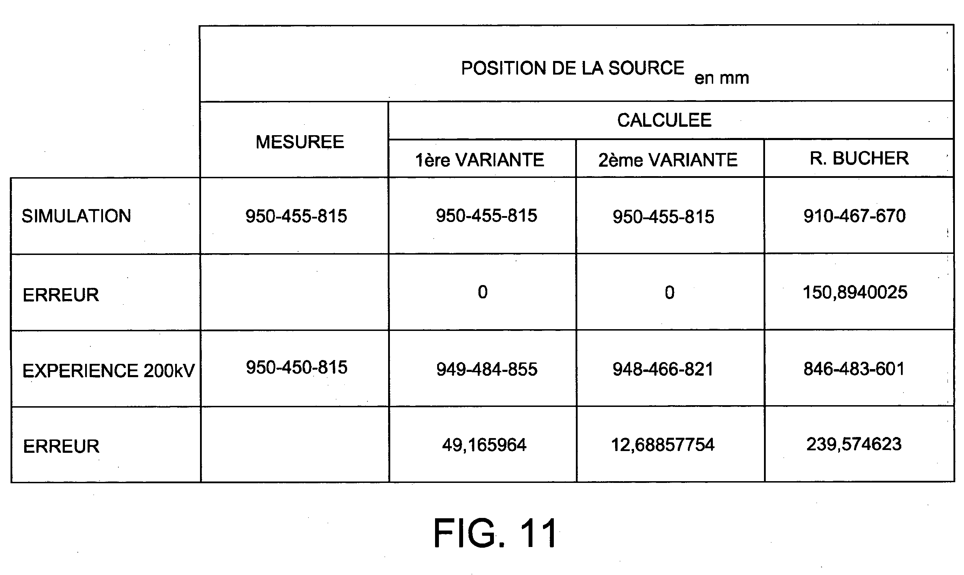

La figure 11 est un tableau regroupant des résultats simulés et expérimentaux de la position de la source de décharge partielle et les erreurs correspondantes obtenues par les deux variantes du procédé selon l'invention et par un procédé connu sous le nom de R. BUCHER qui est un procédé de triangulation traditionnel. L'erreur correspond à la distance séparant la position de la source simulée ou expérimentale de la position vraie qui est connue. Les erreurs sont de 0 pour les deux variantes (positions simulées), et de 49 mm première variante, 12,7 mm seconde variante (positions expérimentales), alors qu'elles atteignent respectivement 151 mm et 240 mm par le procédé R. BUCHER.

Bien que plusieurs modes de réalisation de la présente invention aient été représentés et décrits de façon détaillée, on comprendra que différents changements et modifications puissent être apportés sans sortir du cadre de l'invention.

**DOCUMENTS CITÉS** :

**[1]** « Partial discharge ultrasonic wave propagation in steel transformer tanks » Phung Janmes, Blackburn Su, 7th International Symposium on High Voltage Engineering, Technische Universität Dresden, Aug. 26-30, 1991, pages 131-134.
**[2]** brevet US 3 622 872
**[3]** demande de brevet WO 94/28566
**[4]** demande de brevet WO 01/18554
**[5]** brevet US 4 095 173
**[6]** demande de brevet EP 0 518 508
**[7]** demande de brevet WO 97/24742
**[8]** demande de brevet WO 96/18112
**[9]** brevet US 3 728 619
**[10]** demande de brevet FR 2 304 088

**Revendications**

1. Procédé de détection et de localisation d'une source de décharge partielle (S) dans un appareil électrique placé dans une enceinte (1) contenant un fluide (2) acoustiquement conducteur, comportant les étapes suivantes:

   - positionnement (32, 52) de N détecteurs acoustiques, aptes à détecter une onde acoustique émise par la source de décharge partielle, contre l'extérieur de l'enceinte et acquisition (33, 53) de la position des N détecteurs acoustiques ;

**caractérisé en ce qu'**il comporte les étapes suivantes :

- définition (35, 55), parmi les N détecteurs acoustiques, de P groupes de détecteurs acoustiques avec P = Z ! / (3 ! (Z-3) !), chaque groupe comportant trois détecteurs et Z étant égal à N étant égal à 3 ou plus, ou quatre détecteurs et Z étant égal à N-1 étant égal à 3 ou plus ;

- réalisation (37, 57) d'une première vérification pour s'assurer que chaque groupe est exempt de triangle, à sommets matérialisés par trois détecteurs acoustiques, dont au moins un angle est hors d'une plage d'angles prédéterminée, dans le cas contraire élimination du groupe ;

- pour chaque groupe non éliminé après la première vérification, calcul (38, 58) d'une position approchée de la source de décharge partielle à partir de la position des détecteurs acoustiques du groupe et de l'instant de réception de l'onde acoustique émise par la source de décharge partielle par chacun des détecteurs du groupe ;

- réalisation (39, 59) d'une seconde vérification pour s'assurer que chaque groupe, non éliminé après la première vérification, est exempt de triangle, à sommets matérialisés par deux des détecteurs groupe et par la position approchée de la source de décharge partielle, dont moins un angle est hors de la plage prédéterminée, dans le cas contraire élimination du groupe ;

- calcul (44, 63) de la position recherchée de la source de décharge partielle, en effectuant une moyenne des positions approchées calculées pour tout ou partie des groupes non éliminés après la seconde vérification.

2. Procédé selon la revendication 1, **caractérisé en ce que** la plage d'angles s'étend entre 30° et 151° bornes incluses.

3. Procédé selon l'une des revendications 1 ou 2, **caractérisé en ce qu'**il comprend en outre les étapes suivantes :

   - acquisition (34, 54) des dimensions de l'enceinte ;
   - réalisation (40, 60) d'une vérification additionnelle pour s'assurer que la position approchée de la source de décharge partielle, calculée pour chacun des groupes non éliminés après la seconde vérification, se trouve à l'intérieur de l'enceinte de l'appareil, dans le cas contraire élimination du groupe.

4. Procédé selon la revendication 3, **caractérisé en ce que** la vérification additionnelle se fait avec une tolérance prédéterminée.

5. Procédé selon l'une des revendications 3 ou 4, **caractérisé en ce que** la moyenne se fait avec les positions approchées calculées pour tout ou partie des groupes non éliminés après la vérification additionnelle.

6. Procédé selon l'une des revendications 1 à 5, **caractérisé en ce qu'**il comporte en outre l'étape suivante :

   - réalisation (43) d'une vérification supplémentaire visant à éliminer au moins un détecteur acoustique conduisant à au moins une position approchée considérée comme aberrante.

7. Procédé selon la revendication 6, **caractérisé en ce que** la vérification supplémentaire consiste :

   a°) à repérer (43.1) parmi les positions approchées de la source de décharge partielle, calculées pour chacun des groupes non éliminés après la vérification réalisée en dernier, au moins une position approchée extrême ;
   b°) à identifier (43.2) au moins un détecteur acoustique à l'origine de cette position approchée extrême et à éliminer (43.3) tout groupe de détecteurs acoustiques comportant le détecteur acoustique identifié ;
   à répéter (43.4) les étapes a°) et b°) tant qu'un paramètre de probabilité d'erreur sphérique SEP, calculé à partir des positions approchées de la source de décharge partielle pour les groupes non éliminés, est supérieur à une valeur prédéterminée.

8. Procédé selon la revendication 7, **caractérisé en ce que** le paramètre SEP est défini par SEP = 0,513 ($\sigma_x + \sigma_y + \sigma_z$) avec $\sigma_x$ écart-type des abscisses des positions approchées de la source de décharge partielle, $\sigma_y$ écart-type des ordonnées des positions approchées de la source de décharge partielle, $\sigma_z$ écart-type des cotes des positions approchées de la source de décharge partielle.

9. Procédé selon l'une des revendications 6 à 8, **caractérisé en ce que** la moyenne se fait avec les positions approchées calculées pour tous les groupes non éliminés après la vérification supplémentaire.

10. Procédé selon l'une des revendications 1 à 9, **caractérisé en ce qu'**il comporte une étape d'application (31, 51) de M détecteurs acoustiques sur la paroi externe de l'enceinte de l'appareil électrique et de sélection (32, 52), parmi les M détecteurs acoustiques, des N détecteurs acoustiques aptes à détecter une onde acoustique émise par la source de décharge partielle.

11. Procédé selon l'une des revendications 1 à 10, **caractérisé en ce que** lorsque Z=N, un groupe est formé d'un triplet de détecteurs acoustiques, le calcul (38) des positions approchées se fait par triangulation en résolvant le système d'équations suivant :

$$(x_{Gi}-xi)^2 + (y_{Gi}-yi)^2 + (z_{Gi}-zi)^2 - v^2(ti-t0)^2 = 0$$

$$(x_{Gi}-xj)^2 + (y_{Gi}-yj)^2 + (z_{Gi}-zj)^2 - v^2(tj-t0)^2 = 0$$

$$(x_{Gi}-xk)^2 + (y_{Gi}-yk)^2 + (z_{Gi}-zk)^2 - v^2(tk-t0)^2 = 0$$

dans lequel $x_{Gi}$, $y_{Gi}$, $z_{Gi}$ représentent la position approchée de la source de décharge partielle, (xi, yi, zi), (xj, yj, zj), (xk, yk, zk) la position des détecteurs acoustiques du triplet, t0 un instant d'émission d'une décharge partielle générée par la source et ti, tj, tk les instants de réception de l'onde acoustique émise par la décharge partielle par chacun des détecteurs acoustiques du triplet, v la vitesse de l'onde acoustique dans le fluide.

12. Procédé selon la revendication 11, **caractérisé en ce que** l'instant d'émission (t0) de la décharge partielle est mesuré par des moyens électriques (8) tels un détecteur de type antenne qui coopère avec l'enceinte (1).

13. Procédé selon l'une des revendications 1 à 10, **caractérisé en ce que** lorsque Z = N - 1, un groupe est formé d'un quadruplet de détecteurs acoustiques incluant un détecteur acoustique servant de référence temporelle, le calcul (58) des positions approchées se faisant par triangulation en résolvant le système d'équations suivant :

$$\sqrt{(x_{Gj}-xj)^2+(y_{Gj}-yj)^2+(z_{Gj}-zj)^2} - \sqrt{(x_{Gj}-xi)^2+(y_{Gj}-yi)^2+(z_{Gj}-zi)^2} - v(tj-ti) = 0$$

$$\sqrt{(x_{Gj}-xk)^2+(y_{Gj}-yk)^2+(z_{Gj}-zk)^2} - \sqrt{(x_{Gj}-xi)^2+(y_{Gj}-yi)^2+(z_{Gj}-zi)^2} - v(tk-ti) = 0$$

$$\sqrt{(x_{Gj}-xl)^2+(y_{Gj}-yl)^2+(z_{Gj}-zl)^2} - \sqrt{(x_{Gj}-xi)^2+(y_{Gj}-yi)^2+(z_{Gj}-zi)^2} - v(tl-ti) = 0$$

dans lequel $x_{Gj}$, $y_{Gj}$, $z_{Gj}$ représentent la position approchée de la source de décharge partielle, (xi, yi, zi), (xj, yj, zj), (xk, yk, zk), (xl, yl, zl) la position des quatre détecteurs acoustiques du quadruplet, ti, tj, tk, tl les instants de réception de l'onde acoustique émise par la décharge partielle par chacun des détecteurs acoustiques du quadruplet, v est la vitesse de l'onde acoustique dans le fluide.

**Patentansprüche**

1.  Verfahren zum Erfassen und Orten einer Teilentladungsquelle (S) in einer elektrischen Einrichtung, die in einem Gehäuse (1) mit einem akustisch leitfähigem Medium (2) angeordnet ist, umfassend die nachfolgenden Schritte:

    - Anordnen (32, 52) von N akustischen Sensoren, die eine von der Teilentladungsquelle ausgegebene, akustische Welle erfassen können, an die Außenseite des Gehäuses und Erfassen (33, 53) der Stellung der N akustischen Sensoren;
    **dadurch gekennzeichnet, dass** es die nachfolgenden Schritte umfasst:
    - Bestimmen (35, 55) von P Gruppen von akustischen Sensoren aus den N akustischen Sensoren, wobei P = Z ! / (3 ! (Z - 3) !), wobei jede Gruppe drei Sensoren enthält und Z gleich N gleich 3 oder mehr ist, oder vier Sensoren enthält und Z gleich N - 1 gleich 3 oder mehr ist;
    - Durchführen (37, 57) einer ersten Überprüfung, um sich zu vergewissern, dass jede Gruppe dreiecksfrei und mit von drei akustischen Sensoren gebildeten Spitzen ist, wovon zumindest ein Winkel sich außerhalb eines vorbestimmten Winkelbereichs liegt, andernfalls Beseitigen der Gruppe;
    - bei jeder Gruppe, die nach der ersten Überprüfung nicht beseitigt wurde, Berechnen (38, 58) einer der Teilentladungsquelle angenäherten Position ausgehend von der Position der akustischen Sensoren der Gruppe und des Moments des Empfangs der von der Teilentladungsquelle ausgegebenen akustischen Welle von jedem der Sensoren der Gruppe;
    - Durchführen (39, 59) einer zweiten Überprüfung, um sich zu vergewissern, dass jede Gruppe, die nach der ersten Überprüfung nicht beseitigt wurde, dreiecksfrei und mit von zwei der Gruppensensoren und durch die der Teilentladungsquelle angenäherte Position gebildeten Spitzen ist, wovon zumindest ein Winkel außerhalb des vorbestimmten Winkelbereichs liegt, andernfalls Beseitigen der Gruppe;
    - Berechnen (44, 63) der gesuchten Position der Teilentladungsquelle durch Ermitteln eines Mittelwerts des angenäherten Positionen, die für die gesamten Gruppen oder eines Teils davon berechnet wurden, die nach der zweiten Überprüfung nicht beseitigt wurden.

2.  Verfahren nach Anspruch 1, **dadurch gekennzeichnet, dass** der Winkelbereich sich zwischen 30 ° und 151 ° einschließlich erstreckt.

3.  Verfahren nach einem der Ansprüche 1 oder 2, **dadurch gekennzeichnet, dass** es ferner die nachfolgenden Schritte umfasst:

    - Erfassen (34, 54) der Abmessungen des Gehäuses;
    - Durchführen (40, 60) einer zusätzlichen Überprüfung, um sich zu vergewissern, dass die der Teilentladungsquelle angenäherte Position, die für jede der nach der zweiten Überprüfung nicht beseitigte Gruppe errechnet wurde, sich innerhalb des Gehäuses der Einrichtung befindet, andernfalls Beseitigen der Gruppe.

4.  Verfahren nach Anspruch 3, **dadurch gekennzeichnet, dass** die zusätzliche Überprüfung mit einer vorbestimmten Toleranz erfolgt.

5.  Verfahren nach einem der Ansprüche 3 oder 4, **dadurch gekennzeichnet, dass** der Mittelwert mit angenäherten Positionen ermittelt wird, die für die gesamten Gruppen oder eines Teils davon errechnet wurden, die nach der zusätzlichen Überprüfung nicht beseitigt wurden.

6.  Verfahren nach einem der Ansprüche 1 bis 5, **dadurch gekennzeichnet, dass** es ferner den nachfolgenden Schritt umfasst:

    - Durchführen (43) einer weiteren Überprüfung, die dazu bestimmt ist, zumindest einen akustischen Sensor zu beseitigen, der zu zumindest einer angenäherten Position führt, die als abwegig betrachtet wird.

7.  Verfahren nach Anspruch 6, **dadurch gekennzeichnet, dass** die weitere Überprüfung besteht aus:

    a°) Orten (43.1) von zumindest einer angenäherten Endstellung aus den der Teilentladungsquelle angenäherten Positionen, die für jede der nach der zuletzt erfolgten Überprüfung nicht beseitigten Gruppen errechnet wurden;

b°) Identifizieren (43.2) von zumindest einem akustischen Sensor am Ursprung dieser angenäherten Endposition und Beseitigen (43.3) von jeglicher Gruppe von akustischen Sensoren, die den identifizierten akustischen Sensor umfasst;

Wiederholen (43.4) der Schritte a°) und b°) solange ein Wahrscheinlichkeitsparameter über die Wahrscheinlichkeit eines sphärischen Fehlers SEP, der ausgehend von den der Teilentladungsquelle angenäherten Positionen für die nicht beseitigten Gruppen berechnet wird, größer als ein vorbestimmter Wert ist.

8. Verfahren nach Anspruch 7, **dadurch gekennzeichnet, dass** der Parameter SEP bestimmt ist durch SEP = 0.513 $(\sigma_x + \sigma_y + \sigma_z)$ mit $\sigma_x$ Standardabweichung der Abszissen der der Teilentladungsquelle angenäherten Positionen, $\sigma_y$ Standardabweichung der Ordinaten der der Teilentladungsquelle angenäherten Positionen, $\sigma_z$ Standardabweichung der Maße der der Teilentladungsquelle angenäherten Positionen.

9. Verfahren nach einem der Ansprüche 6 bis 8, **dadurch gekennzeichnet, dass** der Mittelwert mit angenäherten Positionen ermittelt wird, die für sämtliche Gruppen errechnet werden, die nach der weiteren Überprüfung nicht beseitigt wurden.

10. Verfahren nach einem der Ansprüche 1 bis 9, **dadurch gekennzeichnet, dass** es einen Schritt (31, 51) des Anbringens von M akustischen Sensoren an die Außenwand des Gehäuses der elektrischen Einrichtung und des Auswählens (32, 52) von N akustischen Sensoren aus den M akustischen Sensoren, die dazu geeignet sind, eine von der Teilentladungsquelle ausgegebene akustische Welle zu erfassen.

11. Verfahren nach einem der Ansprüche 1 bis 10, **dadurch gekennzeichnet, dass** dann, wenn Z = N, eine Gruppe aus einer Dreiergruppe von akustischen Sensoren gebildet wird, wobei die Berechnung (38) der angenäherten Positionen durch Triangulation unter Lösen des nachfolgenden Gleichungssystems erfolgt:

$$(x_{Gi} - xi)^2 + (y_{Gi} - yi)^2 + (z_{Gi} - zi)^2 - v^2 (ti - t0)^2 = 0$$

$$(x_{Gi} - xj)^2 + (y_{Gi} - yj)^2 + (z_{Gi} - zj)^2 - v^2 (tj - t0)^2 = 0$$

$$(x_{Gi} - xk)^2 + (y_{Gi} - yk)^2 + (z_{Gi} - zk)^2 - v^2 (tk - t0)^2 = 0$$

worin $x_{Gi}$, $y_{Gi}$, $z_{Gi}$ die der Teilentladungsquelle angenäherte Position darstellt, (xi, yi, zi), (xj, yj, zy), (xk, yk, zk) die Position der akustischen Sensoren der Dreiergruppe ist, t0 ein Zeitpunkt des Ausgebens einer Teilentladung ist, die von der Quelle erzeugt wird, und ti, tj, tk die Zeitpunkte des Empfangs der akustischen Welle sind, die von der Teilentladung von jedem der akustischen Sensoren der Dreiergruppe ausgegeben wurde, und v die Geschwindigkeit der akustischen Welle in dem Medium ist.

12. Verfahren nach Anspruch 11, **dadurch gekennzeichnet, dass** der Zeitpunkt (t0) der Ausgabe der Teilentladung von elektrischen Mitteln (8) gemessen wird, wie etwa einem Sensor vom Typ Antenne, der mit dem Gehäuse (1) zusammenwirkt.

13. Verfahren nach einem der Ansprüche 1 bis 10, **dadurch gekennzeichnet, dass** dann, wenn Z = N - 1, eine Gruppe aus einer Vierergruppe von akustischen Sensoren gebildet wird, umfassend einen akustischen Sensor, der als zeitlicher Bezugspunkt dient, wobei die Berechnung (58) der angenäherten Positionen durch Triangulation unter Lösen des nachfolgenden Gleichungssystems erfolgt:

$$\sqrt{(x_{Gj} - xj)^2 + (y_{Gj} - yj)^2 + (z_{Gj} - zj)^2} -$$

$$\sqrt{(x_{Gj} - xi)^2 + (y_{Gj} - yi)^2 + (z_{Gj} - zi)^2} - v(tj - ti) = 0$$

$$\sqrt{(x_{Gj} - xk)^2 + (y_{Gj} - yk)^2 + (z_{Gj} - zk)^2} -$$

$$\sqrt{(x_{Gj} - xi)^2 + (y_{Gj} - yi)^2 + (z_{Gj} - zi)^2} - v(tk - ti) = 0$$

$$\sqrt{(x_{Gj} - xl)^2 + (y_{Gj} - yl)^2 + (z_{Gj} - zl)^2} -$$

$$\sqrt{(x_{Gj} - xi)^2 + (y_{Gj} - yi)^2 + (z_{Gj} - zi)^2} - v(tl - ti) = 0$$

worin $x_{Gj}$, $y_{Gj}$, $z_{Gj}$ die der Teilentladungsquelle angenäherte Position darstellen, (xi, yi, zi), (xj, yj, zy), (xk, yk, zk), (xl, yl, zl) die Position der vier akustischen Sensoren der Vierergruppe ist, ti, tj, tk, tl die Zeitpunkte des Empfangs der akustischen Welle sind, die von der Teilentladung von jedem der akustischen Sensoren der Vierergruppe ausgegeben wurde, und v die Geschwindigkeit der akustischen Welle in dem Medium ist.

## Claims

1. A method of detecting and localizing a source (S) of partial discharge in an electrical apparatus placed in an enclosure (1) containing an acoustically-conductive fluid (2), comprising the following steps:

   positioning (32, 52) against the outside of the enclosure N acoustic detectors suitable for detecting an acoustic wave emitted by the source of partial discharge, and acquiring (33, 53) the positions of the N acoustic detectors; **characterized in that** it comprises le following steps:

   from the N acoustic detectors, defining (35, 55) P groups of acoustic detectors such as P=2!/(3!(2-3)!), each group comprising three detectors and Z being equal to N being equal to 3 or more, or four detectors and Z being equal to N-1 being equal to 3 or more;
   performing (37, 57) a first check to verify that each group is free from any triangle having vertices embodied by three acoustic detectors in which at least one angle lies outside a predetermined range of angles, and otherwise eliminating the group;
   for each group that is not eliminated after the first check, calculating (38, 58) an approximate position for the source of partial discharge from the positions of the acoustic detectors of the group and the instants the acoustic wave emitted by the source of partial discharge is received by each of the detectors of the group;
   performing (39, 59) a second check to verify that each group that is not eliminated after the first check is free from any triangle having vertices embodied by two of the detectors of the group and by the approximate position of the source of partial discharge with at least one angle lying outside the predetermined range, and otherwise eliminating the group; and
   calculating (44, 63) the looked-for position of the source of partial discharge by averaging the approximate positions calculated for all or some of the groups that are not eliminated after the second check.

2. A method according to claim 1, **characterized in that** the range of angles extends from 30° to 151° (end values included).

3. A method according to claim 1 or claim 2, **characterized in that** it further comprises the following steps:

   • acquiring (34, 54) the dimensions of the enclosure; and
   • performing (40, 60) an additional check to verify that the approximate position of the source of partial discharge, as calculated for each of the groups that is not eliminated after the second check, lies inside the enclosure of the apparatus, and otherwise eliminating the group.

**4.** A method according to claim 3, **characterized in that** the additional check is performed with predetermined tolerance.

**5.** A method according to claim 3 or claim 4, **characterized in that** the average is taken using the approximate positions calculated for or some of the groups that are not eliminated after the additional check.

**6.** A method according to any one of claims 1 to 5, **characterized in that** it further includes the following step:

   • performing (43) a supplementary check seeking to eliminate at least one acoustic detector that has led to at least one approximate position considered as being deviant.

**7.** A method according to claim 6, **characterized in that** the supplementary check consists:

   a) in identifying (43.1) at least one extreme approximate position from amongst the approximate positions for the source of partial discharge as calculated for each of the groups that is not eliminated after the last-performed check;
   b) in identifying (43.2) at least one acoustic detector at the origin of this extreme approximate position and in eliminating (43.3) any group of acoustic detectors that include the identified acoustic detector; and
   in repeating (43.4) steps a) and b) so long as a spherical error probability (SEP) parameter calculated from the approximate positions for the source of partial discharge from the non-eliminated groups remains greater than a predetermined value.

**8.** A method according to claim 7, **characterized in that** the SEP parameter is defined by SEP = 0.513 $(\sigma_x + \sigma_y + \sigma_z)$ where $\sigma_x$ is the standard deviation along the x-axis for the approximate positions of the source of partial discharge, $\sigma_y$ is the standard deviation along the y-axis of the approximate positions for the source of partial discharge, and where $\sigma_z$ is the standard deviation along the z-axis of the approximate positions for the source of partial discharge.

**9.** A method according to any one of claims 6 to 8, **characterized in that** the average is taken using the approximate positions calculated for all of the groups that are not eliminated after the supplementary check.

**10.** A method according to any one of claims 1 to 9, **characterized in that** it includes a step of applying (31, 51) M acoustic detectors to the outside wall of the enclosure of an electrical apparatus, and selecting (32, 52) amongst the M acoustic detectors, N acoustic detectors suitable for detecting an acoustic wave emitted by the source of partial discharge.

**11.** A method according to any one of claims 1 to 10, **characterized in that** when Z = N, a group is formed from a triplet of acoustic detectors, with the approximate positions being calculated (38) by triangulation, by solving the following system of equations:

$$(x_{Gi}-xi)^2 + (y_{Gi}-yi)^2 + (z_{Gi}-zi)^2 - v^2(ti-t0)^2 = 0$$

$$(x_{Gi}-xj)^2 + (y_{Gi}-yj)^2 + (z_{Gi}-zj)^2 - v^2(tj-t0)^2 = 0$$

$$(x_{Gi}-xk)^2 + (y_{Gi}-yk)^2 + (z_{Gi}-zk)^2 - v^2(tk-t0)^2 = 0$$

in which $x_{Gi}$, $y_{Gi}$, $z_{Gi}$ represent the approximate position of the source of partial discharge, (xi, yi, zi), (xj, yj, zj), (xk, yk, zk) represent the positions of the acoustic detectors of the triplet, t0 represents an instant at which a partial discharge generated by the source is emitted, and ti, tj, tk represent the instants at which the acoustic wave emitted by the partial discharge is picked up by each of the acoustic detectors of the triplet, and v represents the speed of the acoustic wave in the fluid.

**12.** A method according to claim 11, **characterized in that** the instants (t0) of the emission of the partial discharge is measured by electrical means (8) such as an antenna type detector which cooperates with the enclosure (1).

**13.** A method according to any one of claims 1 to 10, **characterized in that** when Z = N-1, a group is formed by a quadruplet of acoustic detectors including one acoustic detector that acts as a time reference, the approximate positions being calculated (58) by triangulation by solving the following system of equations:

$$\sqrt{(x_{Gj} - xj)^2 + (y_{Gj} - yj)^2 + (z_{Gj} - zj)^2} -$$

$$\sqrt{(x_{Gj} - xi)^2 + (y_{Gj} - yi)^2 + (z_{Gj} - zi)^2} - v(tj - ti) = 0$$

$$\sqrt{(x_{Gj} - xk)^2 + (y_{Gj} - yk)^2 + (z_{Gj} - zk)^2} -$$

$$\sqrt{(x_{Gj} - xi)^2 + (y_{Gj} - yi)^2 + (z_{Gj} - zi)^2} - v(tk - ti) = 0$$

$$\sqrt{(x_{Gj} - xl)^2 + (y_{Gj} - yl)^2 + (z_{Gj} - zl)^2} -$$

$$\sqrt{(x_{Gj} - xi)^2 + (y_{Gj} - yi)^2 + (z_{Gj} - zi)^2} - v(tl - ti) = 0$$

in which $x_{Gj}$, $y_{Gj}$, $z_{Gj}$ represent the approximate position of the source of partial discharge, (xi, yi, zi), (xj, yj, zj), (xk, yk, zk), (xℓ, yℓ, zℓ) represent the positions of the four acoustic detectors of the quadruplets, ti, tj, tk, tℓ represent the instants at which the acoustic wave emitted by the partial discharge is received by each of the acoustic detectors of the quadruplet, and $\underline{v}$ is the speed of the acoustic wave in the fluid.

FIG. 1A

FIG. 1B

FIG. 1C

FIG. 1D

FIG. 2

FIG. 3

## FIG. 4A

POSITIONNEMENT DE
M DETECTEURS ACOUSTIQUES ⟋ 31

SELECTION DE N DETECTEURS
ACOUSTIQUES APTES A
DETECTER UNE ONDE ACOUSTIQUE ⟋ 32

ACQUISITION DE LA POSITION DES
N DETECTEURS ACOUSTIQUES ⟋ 33

ACQUISITION DES
DIMENSIONS DE L'ENCEINTE ⟋ 34

DEFINITION DE P GROUPES DE 3
DETECTEURS AVEC P EGAL A N !/3 !(N-3)! ⟋ 35

SELECTION D'UN DES GROUPES ⟋ 36

NON ← ANGLES DU TRIANGLE MATERIALISE PAR
3 DETECTEURS ACOUSTIQUES DU GROUPE
SELECTIONNE DANS UNE PLAGE D'ANGLES ? ⟋ 37

OUI

CALCUL POSITION APPROCHEE DE LA SOURCE
VUE DU GROUPE SELECTIONNE EN RESOLVANT

$$(x_{Gi}- xi)^2+(y_{Gi}-yi)^2+(z_{Gi}-zi)^2-v^2(ti-t0)^2 = 0$$

$$(x_{Gi}- xj)^2+(y_{Gi}-yj)^2+(z_{Gi}-zj)^2-v^2(tj-t0)^2 = 0$$

$$(x_{Gi}- xk)^2+(y_{Gi}-yk)^2+(z_{Gi}-zk)^2-v^2(tk-t0)^2 = 0$$

⟋ 38

NON ← ANGLES DU TRIANGLE MATERIALISE PAR
2 DETECTEURS ACOUSTIQUES DU GROUPE
SELECTIONNE ET LA POSITION APPROCHEE
CALCULEE DANS UNE PLAGE D'ANGLE ? ⟋ 39

OUI

NON ← POSITION APPROCHEE CALCULEE INCLUSE
A L'INTERIEUR DE L'ENCEINTE ? ⟋ 40

OUI

SAUVEGARDE DE LA POSITION APPROCHEE ⟋ 41

NON ← DERNIER GROUPE SELECTIONNE ? ⟋ 42

OUI

ELIMINATION POSITION APPROCHEE ABERRANTE ⟋ 43

44 ⟋ CALCUL DE LA POSITION RECHERCHEE DE LA SOURCE

REPERAGE POSITION
APPROCHEE EXTREME — 43.1

IDENTIFICATION
DETECTEUR RESPONSABLE — 43.2

ELIMINATION DE
TOUT GROUPE COMPORTANT
DETECTEUR RESPONSABLE — 43.3

43

NON    SEP $\leq$ VALEUR
PREDETERMINEE
43.4

OUI

# FIG. 4B

**FIG. 5**

POSITIONNEMENT DE
M DETECTEURS ACOUSTIQUES — 51

↓

SELECTION DE N DETECTEURS
ACOUSTIQUES APTES A
DETECTER UNE ONDE ACOUSTIQUE — 52

↓

ACQUISITION DE LA POSITION DES
N DETECTEURS ACOUSTIQUES — 53

↓

ACQUISITION DES
DIMENSIONS DE L'ENCEINTE — 54

↓

DEFINITION DE U GROUPES DE 4
DETECTEURS ACOUSTIQUES (UN TRIPLET +
UN DETECTEUR ) AVEC U EGAL A (N-1) !/3 !(N-4)! — 55

↓

SELECTION D'UN DES GROUPES — 56

↓

NON    ANGLES DU TRIANGLE MATERIALISE PAR
LE TRIPLET DU GROUPE SELECTIONNE
DANS UNE PLAGE D'ANGLES ? — 57

↓ OUI

CALCUL POSITION APPROCHEE DE LA SOURCE
VUE DU GROUPE SELECTIONNE EN RESOLVANT — 58

$$\sqrt{(x_{Gj}-xj)^2+(y_{Gj}-yj)^2+(z_{Gj}-zj)^2}-\sqrt{(x_{Gj}-xi)^2+(y_{Gj}-yi)^2+(z_{Gj}-zi)^2}- v(tj-ti) = 0$$

$$\sqrt{(x_{Gj}-xk)^2+(y_{Gj}-yk)^2+(z_{Gj}-zk)^2}-\sqrt{(x_{Gj}-xi)^2+(y_{Gj}-yi)^2+(z_{Gj}-zi)^2}- v(tk-ti) = 0$$

$$\sqrt{(x_{Gj}-xl)^2+(y_{Gj}-yl)^2+(z_{Gj}-zl)^2}-\sqrt{(x_{Gj}-xi)^2+(y_{Gj}-yi)^2+(z_{Gj}-zi)^2}- v(tl-ti) = 0$$

↓

NON    ANGLES DU TRIANGLE MATERIALISE PAR
2 DETECTEURS DU TRIPLET DU GROUPE
SELECTIONNE ET LA POSITION APPROCHEE
CALCULEE DANS UNE PLAGE D'ANGLES ? — 59

↓ OUI

NON    POSITION APPROCHEE CALCULEE INCLUSE
A L'INTERIEUR DE L'ENCEINTE ? — 60

↓ OUI

SAUVEGARDE DE LA POSITION APPROCHEE — 61

↓

NON    DERNIER GROUPE SELECTIONNE ? — 62

↓ OUI

63 — CALCUL DE LA POSITION RECHERCHEE DE LA SOURCE

FIG. 6

| N° groupe | Détecteurs | x | y | z |
|---|---|---|---|---|
| 8 | 3,6,53 | 54 | -391 | -1443 |
| 9 | 3,6,82 | 69 | -384 | -1496 |
| 13 | 5,6,53 | 45 | -410 | -1457 |
| 15 | 5,8,82 | 36 | -435 | -1545 |
| 16 | 5,53,82 | 129 | -419 | -1457 |
| 17 | 6,8,53 | 24 | -469 | -1498 |
| 18 | 6,8,82 | 44 | -453 | -1545 |

| | x | y | z |
|---|---|---|---|
| Moyenne | 57,3 | -423,0 | -1491,6 |
| $\sigma x$ | 34,6 | | |
| $\sigma y$ | 30,6 | | |
| $\sigma z$ | 44,0 | | |
| SEP | 56,0 | | |

FIG. 10

| N° groupe | Détecteurs | x | y | z |
|---|---|---|---|---|
| 1 | 1,3,5 | -21 | -387 | -1200 |
| 2 | 1,3,6 | 29 | -415 | -1255 |
| 3 | 1,5,82 | 172 | -417 | -1414 |
| 4 | 1,6,53 | 97 | -309 | -1375 |
| 5 | 1,6,82 | 117 | -287 | -1402 |
| 6 | 1,52,53 | 121 | -334 | -1393 |
| 7 | 1,52,82 | 132 | -323 | -1407 |
| 8 | 3,6,53 | 54 | -391 | -1443 |
| 9 | 3,6,82 | 69 | -384 | -1496 |
| 10 | 3,52,53 | -56 | -327 | -1393 |
| 11 | 3,52,82 | 368 | -583 | -1236 |
| 12 | 5,6,52 | 43 | -389 | -1324 |
| 13 | 5,6,53 | 45 | -410 | -1457 |
| 14 | 5,8,52 | -151 | -401 | -1324 |
| 15 | 5,8,82 | 36 | -435 | -1545 |
| 16 | 5,53,82 | 129 | -419 | -1457 |
| 17 | 6,8,53 | 24 | -469 | -1498 |
| 18 | 6,8,82 | 44 | -453 | -1545 |
| 19 | 6,52,53 | 85 | -329 | -1393 |
| 20 | 6,52,82 | 106 | -306 | -1424 |

| | | | | |
|---|---|---|---|---|
| Moyenne | | 72,2 | -388,4 | -1399,1 |
| $\sigma x$ | | 101,0 | | |
| $\sigma y$ | | 71,4 | | |
| $\sigma z$ | | 78,0 | | |
| SEP | | 128,4 | | |

**FIG. 7**

| N° groupe | Détecteurs | x | y | z |
|---|---|---|---|---|
| 1 | 1,3,5 | -21 | -387 | -1200 |
| 2 | 1,3,6 | 29 | -415 | -1255 |
| 3 | 1,5,82 | 172 | -417 | -1414 |
| 4 | 1,6,53 | 97 | -309 | -1375 |
| 5 | 1,6,82 | 117 | -287 | -1402 |
| 8 | 3,6,53 | 54 | -391 | -1443 |
| 9 | 3,6,82 | 69 | -384 | -1496 |
| 13 | 5,6,53 | 45 | -410 | -1457 |
| 15 | 5,8,82 | 36 | -435 | -1545 |
| 16 | 5,53,82 | 129 | -419 | -1457 |
| 17 | 6,8,53 | 24 | -469 | -1545 |
| 18 | 6,8,82 | 44 | -453 | -1547 |

| | | | | |
|---|---|---|---|---|
| Moyenne | | 66,3 | -398,0 | -1420,5 |
| $\sigma x$ | | 53,5 | | |
| $\sigma y$ | | 55,8 | | |
| $\sigma z$ | | 56,5 | | |
| SEP | | 85,1 | | |

**FIG. 9**

EP 1 586 911 B1

FIG. 8A

FIG. 8B

FIG. 8C

| | POSITION DE LA SOURCE en mm | | | |
|---|---|---|---|---|
| | MESUREE | CALCULEE | | |
| | | 1ère VARIANTE | 2ème VARIANTE | R. BUCHER |
| SIMULATION | 950-455-815 | 950-455-815 | 950-455-815 | 910-467-670 |
| ERREUR | | 0 | 0 | 150,8940025 |
| EXPERIENCE 200kV | 950-450-815 | 949-484-855 | 948-466-821 | 846-483-601 |
| ERREUR | | 49,165964 | 12,68857754 | 239,574623 |

## FIG. 11

EP 1 586 911 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9618112 A
- FR 0302388
- FR 2851852
- US 3622872 A
- WO 9428566 A
- WO 0118554 A
- US 4095173 A
- EP 0518508 A
- WO 9724742 A
- US 3728619 A
- FR 2304088

**Littérature non-brevet citée dans la description**

- **PHUNG JANMES ; BLACKBURN SU.** Partial discharge ultrasonic wave propagation in steel transformer tanks. *7th International Symposium on High Voltage Engineering,* 26 Août 1991, 131-134